# EUROPÄISCHE PATENTSCHRIFT

(11) **EP 2 149 161 B1**
(45) Veröffentlichungstag und Bekanntmachung des Hinweises auf die Patenterteilung: **04.01.2017**
(21) Anmeldenummer: 08748783.1
(22) Anmeldetag: 25.04.2008
(51) Int. Cl.: H01L 33/00

(54) **OPTOELEKTRONISCHES BAUELEMENT**
OPTOELECTRONIC COMPONENT
COMPOSANT OPTOÉLECTRONIQUE

(30) Priorität: 26.04.2007 DE 102007019775
(43) Veröffentlichungstag der Anmeldung: 03.02.2010
(73) Patentinhaber: OSRAM Opto Semiconductors GmbH, 93055 Regensburg (DE)
(72) Erfinder: ILLEK, Stefan, 93093 Donaustauf (DE); PLOESSL, Andreas, 93051 Regensburg (DE); HEINDL, Alexander, 93326 Abensberg (DE); RODE, Patrick, 93051 Regensburg (DE); EISSLER, Dieter, 93152 Nittendorf/Etterzhausen (DE)
(74) Vertreter: Epping - Hermann - Fischer
(86) Internationale Anmeldenummer: PCT/DE2008/000715
(87) Internationale Veröffentlichungsnummer: WO 2008/131743

(56) Entgegenhaltungen:
- DE-A1-102005 007 601
- JP-A- 2004 047 504
- JP-A- 2007 095 821
- US-A1- 2008 029 761

## Beschreibung

Die Erfindung betrifft ein optoelektronisches Bauelement.

Ein optoelektisches Element ist in DE 10 2005 007 601 A1 beschrieben, das einen Halbleiterfunktionsbereich mit einer aktiven Zone und einer lateralten Haupterstreckungsrichtung umfasst, wobei der Halbleiterfunktionsbereich zumindest einen Durchbruch durch die aktive Zone umfasst, im Bereich des Durchbruchs ein Verbindungsleitermaterial angeordnet ist, das von der aktiven Zone zumindest in einem Teilbereich des Durchbruchs elektrisch isoliert ist.

Eine Aufgabe der vorliegenden Erfindung ist es, ein effizientes optoelektronisches Bauelement, insbesondere ein effizientes strahlungsemittierendes Bauelement anzugeben.

Diese Aufgabe wird durch ein Bauelement gemäß dem unabhängigen Patentanspruch gelöst. Vorteilhafte Ausgestaltungen und Weiterbildungen sind Gegenstand der abhängigen Patentansprüche.

Ein optoelektronisches Bauelement umfasst gemäß einer ersten Ausführungsform einen Halbleiterkörper, der eine Halbleiterschichtenfolge mit einem aktiven Bereich aufweist. Weiterhin umfasst das Bauelement zwei elektrische Kontakte, die auf verschiedenen Seiten des aktiven Bereichs elektrisch leitend mit dem Halbleiterkörper verbunden sind. Dabei ist ein Teilbereich eines ersten Kontakts der beiden Kontakte zwischen dem Halbleiterkörper und dem zweiten Kontakt der beiden Kontakte angeordnet und die beiden Kontakte sind in diesem Teilbereich elektrisch voneinander isoliert.
Mit anderen Worten ausgedrückt weist das optoelektronische Bauelement zwei auf dem Halbleiterkörper angeordnete und miteinander auf der gleichen Seite des aktiven Bereichs überlappende Kontakte auf, wobei die Kontakte auf verschiedenen Seiten des aktiven Bereichs elektrisch leitend mit dem Halbleiterkörper verbunden sind und die Kontakte im Überlappbereich elektrisch voneinander isoliert sind.

Da beide Kontakte in dem Überlappungsbereich auf der gleichen Seite des Halbleiterkörpers und insbesondere des aktiven Bereichs angeordnet sind, kann sowohl die elektrische Kontaktbildung zum Halbleiterkörper mittels des einen Kontakts als auch eine Stromaufweitung über die laterale Erstreckungsrichtung des aktiven Bereichs mittels des anderen Kontakts auf der gleichen Seite des Halbleiterkörpers und insbesondere des aktiven Bereichs erzielt werden. Die verbleibenden Seiten des Halbleiterkörpers können somit im wesentlichen frei oder frei von metallhaltigen oder metallischen Kontaktelementen, wie etwa elektrischen Kontakt zum Halbleiterkörper bildenden beziehungsweise stromaufweitenden Strukturen, sein. Derart großflächige und oftmals maßgeblich absorbierende Kontaktelemente können somit auf der gleichen Seite des Halbleiterkörpers angeordnet sein.

Eine Auskoppelfläche des Bauelements kann damit vereinfacht frei oder im wesentlichen frei von derart absorbierenden Elementen sein. Die aus dem Bauelement auskoppelbare Strahlungsleistung kann so vorteilhaft erhöht sein.

In einer bevorzugten Ausgestaltung ist der aktiven Bereich zur Strahlungserzeugung geeignet. Der aktive Bereich kann zur Erzeugung von Strahlung im ultravioletten, sichtbaren oder infraroten Spektralbereich ausgebildet sein.

In einer weiteren bevorzugten Ausgestaltung ist in dem Teilbereich, in dem der erste Kontakt zwischen dem Halbleiterkörper und dem zweiten Kontakt angeordnet ist, eine Isolationsschicht zwischen den beiden Kontakten angeordnet, über die die beiden Kontakte elektrisch voneinander isoliert sind. Ein Kurzschluss der beiden Kontakte kann so vermieden werden.

In einer weiteren bevorzugten Ausgestaltung ist ein Teilbereich des zweiten Kontakts zwischen dem Halbleiterkörper und dem ersten Kontakt angeordnet und die beiden Kontakte sind in diesem Teilbereich elektrisch voneinander isoliert. Bevorzugt ist eine gegebenenfalls weitere Isolationsschicht vorgesehen, die in diesem Teilbereich zwischen den beiden Kontakten angeordnet ist und die Kontakte elektrisch voneinander isoliert.

Vom Halbleiterkörper aus gesehen kann in einem Teilbereich des Bauelements folgende Abfolge vorliegen: Bereich des ersten Kontakts, Isolationsschicht, Bereich des zweiten Kontakts, weitere Isolationsschicht, weiterer Bereich des ersten Kontakts.

Die Isolationsschicht(en) ist(sind) mit Vorzug auf den Halbleiterkörper aufgebracht, besonders bevorzugt auf dem Halbleiterkörper abgeschieden. Ein für die Isolationsschicht(en) geeignetes Material ist beispielsweise ein Siliziumnitrid, ein Siliziumoxid oder ein Siliziumoxinitrid.

In einer weiteren bevorzugten Ausgestaltung ist eine Reflektorschicht auf dem Halbleiterkörper angeordnet. Die Reflektorschicht ist vorzugsweise auf dem Halbleiterkörper abgeschieden. Mittels der Reflektorschicht kann aus dem Halbleiterkörper austretende und auf die Reflektorschicht treffende Strahlung in den Halbleiterkörper zurück reflektiert werden. Einer Absorption von Strahlung in auf der vom aktiven Bereich abgewandten Seite der Reflektorschicht angeordneten Elementen kann so vorgebeugt werden.

Insgesamt kann mittels einer überlappenden Anordnung der Kontakte auf einer gemeinsamen Seite des Halbleiterkörpers die Auskoppeleffizienz - das Verhältnis von im aktiven Bereich erzeugter Strahlungsleistung zu der aus dem Bauelement ausgekoppelten Strahlungsleistung - erhöht werden.

Ein optoelektronisches Bauelement gemäß einer weiteren Ausführungsform umfasst einen Halbleiterkörper, der eine Halbleiterschichtenfolge mit einem zur Strahlungserzeugung geeigneten aktiven Bereich aufweist. Weiterhin umfasst das optoelektronische Bauelement eine auf dem Halbleiterkörper angeordnete Reflektorschicht und zwei elektrische Kontakte. Dabei ist ein erster Kontakt der beiden Kontakte auf der der Reflektorschicht zugewandten Seite des aktiven Bereichs elektrisch leitend mit dem Halbleiterkörper verbunden. Der zweite Kontakt der beiden Kontakte ist auf der von der Reflektorschicht abgewandten Seite des aktiven Bereichs elektrisch leitend mit dem Halbleiterkörper verbunden, wobei die Reflektorschicht, insbesondere ein Teil der Reflektorschicht; zwischen einem Teilbereich des zweiten Kontakts und dem Halbleiterkörper angeordnet ist.

Da die Reflektorschicht zwischen dem zweiten Kontakt und dem Halbleiterkörper und insbesondere dem aktiven Bereich angeordnet ist, kann eine Absorption von Strahlung in dem auf der vom aktiven Bereich abgewandten Seite der Reflektorschicht angeordneten Teilbereich des Kontakts gemindert oder vermieden werden.

Die Reflektorschicht ist zweckmäßigerweise für im aktiven Bereich zu erzeugende Strahlung reflektierend ausgebildet. Die Reflektorschicht weist für die im aktiven Bereich erzeugte Strahlung zweckmäßigerweise eine Reflektivität von 80% oder mehr, bevorzugt von 90% oder mehr, besonders bevorzugt von 95% oder mehr auf.

In einer weiteren bevorzugten Ausgestaltung ist die Reflektorschicht elektrisch isolierend ausgebildet. Eine elektrisch isolierende Reflektorschicht kann beispielsweise als dielektrische Mehrschichtstruktur, die abwechselnd Schichten mit hohen und niedrigen Brechungsindices aufweist, ausgeführt sein.

Zweckmäßigerweise ist die Reflektorschicht für die Kontaktbildung zum Halbleiterkörper mittels eines der Kontakte - des ersten Kontakts oder des zweiten Kontakts -, besonders bevorzugt für die Kontaktbildung zum Halbleiterkörper über beide Kontakte ausgespart. Letzteres ist besonders zweckmäßig, falls die Reflektorschicht elektrisch isolierend ausgebildet ist.

In einer weiteren bevorzugten Ausgestaltung weist einer der Kontakte, bevorzugt der erste Kontakt, die Reflektorschicht auf. Die Reflektorschicht ist dann elektrisch leitfähig ausgeführt. Die leitfähige Reflektorschicht enthält bevorzugt ein Metall oder eine Legierung, die vorzugsweise ein Metall enthält. Metalle zeichnen sich durch besonders hohe Reflektivitäten aus. Im Vergleich zu einer dielektrischen Mehrschichtstruktur ist die Abhängigkeit der Reflektivität einer Reflektorschicht, die eine Metallisierung oder eine metallbasierte Legierung aufweist, vom Einfallswinkel auf die Reflektorschicht gering.

Bevorzugt sind die Kontakte auf den Halbleiterkörper aufgebracht und besonders bevorzugt mittels Abscheidens auf den Halbleiterkörper ausgebildet. Ein Kontakt oder beide Kontakte können eine Kontaktmetallisierung oder eine Kontaktlegierung umfassen.

In einer weiteren bevorzugten Ausgestaltung weist der erste Kontakt eine Kontaktschicht auf, über die der erste Kontakt mit dem Halbleiterkörper elektrisch leitend verbunden ist. Vorzugsweise grenzt die Kontaktschicht unmittelbar an den Halbleiterkörper an. Ein Teilbereich der Kontaktschicht kann zwischen dem zweiten Kontakt und dem Halbleiterkörper angeordnet sein.

Die Kontaktschicht kann als Reflektorschicht ausgebildet sein oder die Reflektorschicht kann auf der vom Halbleiterkörper abgewandten Seite der Kontaktschicht angeordnet sein. Die letztere Variante einer gesondert vorgesehenen Kontaktschicht hat den Vorteil, dass für die Kontaktbildung zum Halbleiterkörper und für die Reflektorschicht jeweils besonders geeignete Materialien - für gute Kontaktbildung zum Halbleiterkörper mittels der Kontaktschicht bzw. für eine hohe Reflektivität der Reflektorschicht - verwendet werden können.

In einer weiteren bevorzugten Ausgestaltung ist auf dem Halbleiterkörper eine Haftschicht angeordnet. Die Haftschicht grenzt vorzugsweise unmittelbar an den Halbleiterkörper an. Die Haftschicht ist bevorzugt derart ausgebildet, dass die Haftung von Material für einen der Kontakte, insbesondere für den ersten Kontakt, am Halbleiterkörper erhöht wird. Die Haftschicht kann als Haftschicht für den ersten Kontakt ausgebildet sein. Die Haftschicht kann insbesondere derart ausgebildet sein, dass die Haftschicht an dem Halbleiterkörper stärker haftet als ein auf der vom Halbleiterkörper abgewandten Seite der Haftschicht angeordnetes, insbesondere an die Haftschicht angrenzendes, Material des ersten Kontakts. Die Haftschicht kann alternativ oder ergänzend derart ausgebildet sein, dass das auf der vom Halbleiterkörper angeordnete Seite der Haftschicht angeordnete, insbesondere an die Haftschicht angrenzende, Material des ersten Kontakts an der Haftschicht stärker haftet als am Halbleiterkörper.

Die Haftschicht kann elektrisch leitfähig ausgeführt sein. Die Haftschicht kann Teil eines der Kontakte, insbesondere des ersten Kontakts, sein. Die Haftschicht enthält mit Vorzug ein Metall oder eine Legierung oder besteht daraus. Beispielsweise enthält die Haftschicht Ti. Die Haftschicht kann zwischen der Kontaktschicht und dem Halbleiterkörper bzw. zwischen der Reflektorschicht und dem Halbleiterkörper angeordnet sein. Vorzugsweise grenzt die Haftschicht unmittelbar an die Kontaktschicht und/oder den Halbleiterkörper an. Mit Vorteil ist die Haftschicht vollflächig zwischen der Kontaktschicht bzw. der Reflektorschicht und dem Halbleiterkörper angeordnet. Die Gefahr einer Delamination von Kontaktmaterial vom Halbleiterkörper kann so verringert werden. Die Haftschicht kann eine Dicke von 10 nm oder weniger, bevorzugt von 5 nm oder weniger, besonders bevorzugt von 3 nm oder weniger, wie etwa 2 nm oder weniger, aufweisen. Die Haftschicht kann semitransparent ausgebildet sein. Die Haftschicht kann als nicht durchgehende, z. B. inselartig, ausgebildete Schicht ausgeführt sein.

In einer weiteren bevorzugten Ausgestaltung ist zwischen der elektrisch leitfähigen Reflektorschicht des ersten Kontakts und dem Halbleiterkörper eine dielektrische Spiegelschicht - also eine elektrisch isolierende Spiegelschicht - angeordnet. Die Spiegelschicht kann zwischen der Reflektorschicht und der Kontaktschicht oder zwischen der Kontaktschicht und der Haftschicht angeordnet sein.

Die dielektrische Spiegelschicht kann in Kombination mit der Reflektorschicht eine Rückreflexion von Strahlung in den Halbleiterkörper und insbesondere die Reflexion von Strahlung zu einer Auskoppelfläche des Bauelements weitergehend verbessern. Insbesondere kann ein kombinierter Spiegel, welcher die Reflektorschicht und die dielektrische Spiegelschicht umfasst, mit einer hohen Gesamtreflektivität ausgebildet werden.

In einer weiteren bevorzugten Ausgestaltung ist auf dem Halbleiterkörper, insbesondere auf der Seite, auf der die Reflektorschicht und/oder die Kontaktschicht angeordnet ist, eine elektrisch leitfähige und strahlungsdurchlässige Schicht angeordnet. Diese Schicht kann Teil des ersten Kontakts sein.

Die strahlungsdurchlässige und elektrisch leitfähige Schicht kann ein Oxid, insbesondere ein Metalloxid, zum Beispiel ein Zinkoxid, ein Zinnoxid oder ein Indiumzinnoxid enthalten.

Die strahlungsdurchlässige und elektrisch leitfähige Schicht ist weiterhin bevorzugt zur lateralen Stromverteilung über eine Haupterstreckungsrichtung des Halbleiterkörpers, insbesondere als Stromaufweitungsschicht, ausgebildet. Aufgrund der hohen Leitfähigkeit in lateraler Richtung (Querleitfähigkeit) können Ladungsträger lateral großflächig und homogen über den Halbleiterkörper verteilt werden und so homogen und gleichmäßig über den Halbleiterkörper verteilt in den Halbleiterkörper injiziert werden.

Die strahlungsdurchlässige und elektrisch leitfähige Schicht kann einen Brechungsindex aufweisen, der kleiner ist als der eines den Halbleiterkörper seitens der Schicht begrenzenden Halbleitermaterials. Aufgrund des Brechungsindexsprungs kann die Schicht als elektrisch'leitfähige und strahlungsdurchlässige Spiegelschicht des ersten Kontakts ausgebildet sein.

Die strahlungsdurchlässige und elektrisch leitfähige Schicht kann zusätzlich zu einer dielektrischen Spiegelschicht, wie weiter oben beschrieben, vorgesehen sein. Ist zusätzlich eine dielektrische Spiegelschicht vorgesehen, so kann die Gesamtreflektivität auf dieser Seite des Halbleiterkörpers weiterhin erhöht werden. Bevorzugt ist die Schicht zwischen der Reflektorschicht bzw. der Kontaktschicht und dem Halbleiterkörper angeordnet. Die Schicht kann weiterhin zwischen der dielektrischen Spiegelschicht und dem Halbleiterkörper angeordnet sein. Eine Dicke der Schicht kann 200 nm oder weniger, bevorzugt 100 nm oder weniger betragen. Vorzugsweise grenzt die strahlungsdurchlässige und elektrisch leitfähige Schicht unmittelbar an den Halbleiterkörper an. Die strahlungsdurchlässige und elektrisch leitfähige Schicht kann die Kontaktschicht und/oder die Haftschicht ersetzen. Alternativ kann die strahlungsdurchlässige und elektrisch leitfähige Schicht zusätzlich zu der Haftschicht und/oder zu der Kontaktschicht vorgesehen sein. Im ersteren Fall ist die Haftschicht zweckmäßigerweise zur Verbesserung der Haftung der strahlungsdurchlässigen und elektrisch leitfähigen Schicht am Halbleiterkörper ausgebildet. Im letzteren Fall ist die Kontaktschicht zweckmäßigerweise auf eine gute elektrische Kontaktbildung zu der strahlungsdurchlässigen und elektrisch leitfähigen Schicht ausgebildet.

In einer weiteren bevorzugten Ausgestaltung erstreckt sich der zweite Kontakt von dem Teilbereich, in dem der erste Kontakt bzw. die Reflektorschicht zwischen dem Halbleiterkörper und dem zweiten Kontakt angeordnet ist, ausgehend bis zu der von diesem Teilbereich abgewandten Seite des aktiven Bereichs und ist auf dieser Seite elektrisch leitend mit dem Halbleiterkörper verbunden.

In einer weiteren bevorzugten Ausgestaltung erstreckt sich der zweite Kontakt neben einer den Halbleiterkörper lateral begrenzenden Seitenfläche von der einen Seite des aktiven Bereichs bis zur anderen Seite des aktiven Bereichs. Zweckmäßigerweise ist der zweite Kontakt vom aktiven Bereich in der Region, in der er sich über den aktiven Bereich erstreckt, elektrisch isoliert. Beispielsweise ist hierzu eine der oben genannten Isolationsschichten oder gegebenenfalls eine zusätzliche Isolationsschicht zwischen dieser Region des zweiten Kontakts und dem aktiven Bereich vorgesehen.

In einer weiteren bevorzugten Ausgestaltung weist der aktive Bereich einen oder eine Mehrzahl von Durchbrüchen auf. Der zweite Kontakt kann sich durch den Durchbruch von der einen Seite des aktiven Bereichs zur anderen Seite des aktiven Bereichs erstrecken. Im Bereich des Durchbruchs bzw. der Durchbrüche ist der aktive Bereich zweckmäßigerweise ausgespart. Der Durchbruch ist bzw. die Durchbrüche sind bevorzugt lateral umlaufend vom Halbleiterkörper begrenzt. Weiterhin ist der zweite Kontakt im Bereich des Durchbruchs bzw. der Durchbrüche zweckmäßigerweise vom aktiven Bereich elektrisch isoliert. Beispielsweise ist für die elektrische Isolation eine der oben genannten Isolationsschichten oder gegebenenfalls eine zusätzliche Isolationsschicht im Bereich des Durchbruchs bzw. der Durchbrüche zwischen dem zweiten Kontakt und dem aktiven Bereich angeordnet.

Durch eine elektrische Isolation des zweiten Kontakts vom aktiven Bereich in der Region, in der sich der zweite Kontakt über den aktiven Bereich erstreckt, kann ein Kurzschluss des Bauelements vermieden werden.

Die Isolationsschicht kann gegebenenfalls als (zusätzliche) dielektrische Spiegelschicht dienen und insbesondere als solche ausgebildet sein. Auch im Bereich des Durchbruchs kann so Strahlung an einer dielektrischen Spiegelschicht vermehrt in den Halbleiterkörper zurück reflektiert werden.

Eine Wand des (jeweiligen) Durchbruchs verläuft bevorzugt schräg zum aktiven Bereich und/oder schräg zu einer den Halbleiterkörper seitens der Reflektorschicht begrenzenden Oberfläche. Der Strahlengang im Halbleiterkörper kann so weitergehend - zum Beispiel durch Reflexion an der entsprechend verlaufenden dielektrischen Spiegelschicht und/oder dem Kontaktmaterial des zweiten Kontakts, das im Bereich des Durchbruchs angeordnet ist - gestört werden und die ausgekoppelte Strahlungsleistung kann vereinfacht erhöht werden. Ein Winkel für die Schräge von zwischen einschließlich 35° und einschließlich 55°, zum Beispiel 45°, hat sich als besonders vorteilhaft erwiesen.

In einer weiteren bevorzugten Ausgestaltung weist der zweite Kontakt eine Kontaktschicht auf. Die Kontaktschicht ist zweckmäßigerweise für die elektrische Kontaktbildung zum Halbleitermaterial vorgesehen. Die Kontaktschicht ist bevorzugt metallhaltig oder auf Legierungsbasis, insbesondere aus einem Metall oder einer Metalllegierung ausgeführt. Beispielsweise kann die Kontaktschicht Pt enthalten oder daraus bestehen. Die Kontaktschicht kann lokal an einer Kontaktstelle des zweiten Kontakts zum Halbleitermaterial, z. B. im Bereich einer Ausnehmung des Halbleiterkörpers, und vorzugsweise an jeder Kontaktstelle des zweiten Kontakts zum Halbleitermaterial vorgesehen sein.

In einer weiteren bevorzugten Ausgestaltung weist der zweite Kontakt eine elektrisch leitfähige Spiegelschicht auf. Bevorzugt ist diese Spiegelschicht in einem Bereich des zweiten Kontakts angeordnet, in dem dieser Kontakt näher am aktiven Bereich angeordnet ist als die Reflektorschicht. Die Spiegelschicht ist zweckmäßigerweise im Bereich des Durchbruchs durch den aktiven Bereich, z. B. in der Ausnehmung, angeordnet. Die Spiegelschicht kann auf der vom Halbleiterkörper abgewandten Seite der Kontaktschicht des zweiten Kontakts angeordnet sein. Die Kontaktschicht kann zwischen der Spiegelschicht und dem Halbleiterkörper angeordnet sein. Strahlung kann im Bereich des Durchbruchs an der Spiegelschicht vermehrt reflektiert werden. Die Spiegelschicht kann ein Metall, zum Beispiel Al oder Ag, oder eine Legierung enthalten oder daraus bestehen.

In einer weiteren bevorzugten Ausgestaltung ist der erste Kontakt, insbesondere die Kontaktschicht, für den Durchtritt des zweiten Kontakts durchbrochen. Der zweite Kontakt kann sich demnach von der vom aktiven Bereich abgewandten Seite des ersten Kontakts durch den ersten Kontakt, insbesondere durch die Kontaktschicht hindurch, auf die dem aktiven Bereich zugewandte Seite des ersten Kontakts erstrecken.

In einer weiteren bevorzugten Ausgestaltung ist die Reflektorschicht für den Durchtritt des zweiten Kontakts durchbrochen. Der zweite Kontakt kann durch die durchbrochene Reflektorschicht von der von dem aktiven Bereich abgewandten Seite der Reflektorschicht auf die dem aktiven Bereich zugewandte Seite der Reflektorschicht hindurch treten. Bei einer isolierenden Reflektorschicht ist diese bevorzugt auch für die Kontaktbildung des ersten Kontakts zum Halbleiterkörper durchbrochen.

In einer weiteren bevorzugten Ausgestaltung ist der zweite Kontakt in einer Mehrzahl von gesonderten Kontaktstellen elektrisch leitend mit dem Halbleiterkörper verbunden. Die Kontaktstellen sind mit Vorzug gleichmäßig über den Halbleiterkörper verteilt.

In einer weiteren bevorzugten Ausgestaltung verläuft der zweite Kontakt zumindest zum Teil steg- oder rahmenartig neben einer den aktiven Bereich und insbesondere den Halbleiterkörper lateral - also in Erstreckungsrichtung des aktiven Bereichs - begrenzenden Seitenfläche.

In einer weiteren bevorzugten Ausgestaltung ist eine Kontaktfläche des ersten Kontakts, insbesondere deren Flächeninhalt, zum Halbleiterkörper größer als eine Kontaktfläche des zweiten Kontakts, insbesondere deren Flächeninhalt, zum Halbleiterkörper.

In einer weiteren bevorzugten Ausgestaltung ist der zweite Kontakt mit einem Halbleitermaterial des Halbleiterkörpers elektrisch leitend verbunden, das eine größere Leitfähigkeit in lateraler Richtung aufweist als ein Halbleitermaterial des Halbleiterkörpers, mit dem der erste Kontakt elektrisch leitend verbunden ist. Trotz einer kleineren Kontaktfläche zwischen dem zweiten Kontakt und dem Halbleiterkörper kann aufgrund der höheren Leitfähigkeit in lateraler Richtung - also der Leitfähigkeit parallel zu einer Haupterstreckungsrichtung des aktiven Bereichs - vereinfacht eine laterale Stromaufweitung über die Erstreckung des aktiven Bereichs erreicht werden. In den aktiven Bereich können daher trotz der nur kleinflächigen Kontaktierung, z.B. über die Kontaktstellen, großflächig und vorzugsweise homogen Ladungsträger injiziert werden, welche im aktiven Bereich unter Strahlungserzeugung rekombinieren können.

In einer weiteren bevorzugten Ausgestaltung weist der zweite Kontakt einen Stromaufweitungsbereich auf. Ein Teilbereich des ersten Kontakts, insbesondere ein Teilbereich der Kontaktschicht, ist bevorzugt zwischen dem Stromaufweitungsbereich und dem Halbleiterkörper angeordnet. Die gegebenenfalls elektrisch isolierende Reflektorschicht kann zwischen dem Stromaufweitungsbereich und dem Halbleiterkörper angeordnet sein. Der Stromaufweitungsbereich kann eine oder eine Mehrzahl von Kontaktbahnen aufweisen, die sich über den Halbleiterkörper erstreckt. Eine Kontaktbahn kann sich über eine Mehrzahl von Durchbrüchen des aktiven Bereichs erstrecken. Mittels des Stromaufweitungsbereichs kann eine Ladungsträgerverteilung über die Haupterstreckungsrichtung des Halbleiterkörpers erfolgen. Die aufgeweiteten Ladungsträger können dann über die Kontaktfläche des zweiten Kontakts mit dem Halbleiterkörper, z.B. die über den Halbleiterkörper verteilten Kontaktstellen, in den Halbleiterkörper injiziert werden. Über den Stromaufweitungsbereich können Ladungsträger zu den Kontaktstellen geführt werden. Der Stromaufweitungsbereich des zweiten Kontakts ist zweckmäßigerweise vom ersten Kontakt elektrisch isoliert. Ein Kurzschluss der Kontakte kann so vermieden werden.

Beide Kontakte können sich, insbesondere großräumig, über eine gemeinsame Oberfläche des Halbleiterkörpers erstrecken. Seitens dieser Oberfläche sind die Kontakte zweckmäßigerweise voneinander isoliert. Insbesondere kann ein Kontakt bereichsweise in Isolationsmaterial, z. B. die Isolationsschicht und gegebenenfalls die weitere Isolationsschicht, welches die beiden Kontakte voneinander isoliert, eingebettet sein.

In einer weiteren bevorzugten Ausgestaltung weisen die Kontakte jeweils eine Anschlussfläche auf. Die jeweilige Anschlussfläche ist mit Vorzug vom aktiven Bereich abgewandt.

Über die Anschlussflächen kann das Bauelement extern elektrisch kontaktiert werden. Die jeweilige Anschlussfläche ist vorzugsweise zur elektrisch leitenden Verbindung mit einem der Anschlussfläche zugeordneten Anschlussleiter eines externen Anschlussträgers vorgesehen. Der Anschlussträger kann beispielsweise eine Leiterplatte mit Leiterbahnen für die Anschlussleiter sein. Die Anschlussflächen können beispielsweise mittels einer Lotschicht gebildet sein.

In einer weiteren bevorzugten Ausgestaltung ist eine Anschlussfläche eines der Kontakte - also des ersten Kontakts oder des zweiten Kontakts - auf der von der Reflektorschicht, von der dielektrischen Spiegelschicht, von der Kontaktschicht des ersten Kontakts und/oder von dem Teilbereich des ersten Kontakts, der zwischen dem Halbleiterkörper und dem zweiten Kontakt angeordnet ist, abgewandten Seite des aktiven Bereichs und insbesondere des Halbleiterkörpers angeordnet.

In einer weiteren bevorzugten Ausgestaltung sind beide Anschlussflächen auf der gleichen Seite des aktiven Bereichs angeordnet. Das Bauelement kann insbesondere als oberflächenmontierbares Bauelement ausgebildet sein.

In einer weiteren bevorzugten Ausgestaltung ist der erste Kontakt, insbesondere ein Teilbereich von diesem, zwischen dem Halbleiterkörper und der Anschlussfläche des zweiten Kontakts angeordnet. Alternativ oder ergänzend ist der zweite Kontakt, insbesondere ein Teilbereich von diesem, bevorzugt zwischen dem Halbleiterkörper und der Anschlussfläche des ersten Kontakts angeordnet.

Die Kontaktschicht des ersten Kontakts, die Kontaktschicht des zweiten Kontakts, die Reflektorschicht und/oder die dielektrische Spiegelschicht kann zwischen der Anschlussfläche eines der Kontakte - des ersten oder des zweiten Kontakts - und dem Halbleiterkörper, vorzugsweise zwischen den Anschlussflächen beider Kontakte und dem Halbleiterkörper, angeordnet sein. Insbesondere kann sich die Kontaktschicht des ersten Kontakts, die Reflektorschicht und/oder die dielektrische Spiegelschicht von unterhalb der Anschlussfläche des ersten Kontakts - also zwischen der Anschlussfläche und dem Halbleiterkörper - ausgehend bis unter die Anschlussfläche des zweiten Kontakts erstrecken. Der Stromaufweitungsbereich des zweiten Kontakts kann sich bis unter die Anschlussfläche des ersten Kontakts erstrecken.

Die Anschlussflächen beider Kontakte können zur elektrisch leitenden Verbindung mit dem Anschlussträger mittels einer elektrisch leitfähigen Verbindungsschicht, z.B. einer leitfähigen Klebeschicht oder einer Lotschicht, oder eines Bonddrahts vorgesehen sein, wobei beide Kontakte bevorzugt jeweils entweder für die Verbindungsschicht oder die Drahtverbindung ausgelegt sind.

Das Bauelement kann insbesondere flip-chip-artig ausgebildet sein. Ein Flip-Chip wird stoffschlüssig mittels einer elektrisch leitfähigen Verbindungsschicht auf dem Anschlussträger montiert und elektrisch kontaktiert. Für eine derartige Montage ist die Anschlussseite des Bauelements, auf der die Anschlussflächen beider Kontakte angeordnet sind, zweckmäßigerweise die Montageseite des Bauelements, welche dem Anschlussträger zuzuwenden ist.

Bei einer Drahtbondverbindung ist die Montageseite zweckmäßigerweise die den Anschlussflächen abgewandte Seite des Bauelements.

Die Anschlussflächen der Kontakte können auf einer gemeinsamen, vorzugsweise ebenen, Oberfläche des Halbleiterkörpers angeordnet sein. Die Anschlussflächen können sich insbesondere über diese Oberfläche erstrecken. Diese Oberfläche ist vorzugsweise zwischen dem aktiven Bereich und den Anschlussflächen der Kontakte angeordnet. Einer der Kontakte ist zweckmäßigerweise seitens dieser Oberfläche des Halbleiterkörpers, vorzugsweise unmittelbar, elektrisch leitend mit dem Halbleiterkörper verbunden. Der andere Kontakt ist dann zweckmäßigerweise auf der von dieser Oberfläche abgewandten Seite des aktiven Bereichs elektrisch leitend mit dem Halbleiterkörper verbunden.

Beide Anschlussflächen können auf der Seite des aktiven Bereichs angeordnet sein, welche von derjenigen Seite des Halbleiterkörpers, seitens derer der Teilbereich des ersten Kontakts zwischen dem Halbleiterkörper und dem zweiten Kontakt angeordnet ist, abgewandt ist. Die Seite, seitens derer die beiden Anschlussflächen angeordnet sind, kann insbesondere die von der Reflektorschicht, von der Kontaktschicht des ersten Kontakts, von der Kontaktschicht des zweiten Kontakts und/oder von der dielektrischen Spiegelschicht abgewandte Seite des Halbleiterkörpers sein. Die beiden Anschlussflächen können sich über eine gemeinsame Oberfläche des Halbleiterkörpers erstrecken. Die laterale Stromverteilung, die Strominjektion in den Halbleiterkörper und/oder die Reflexion von Strahlung mittels der Reflektorschicht kann auf der von den Anschlussflächen abgewandten Seite des Halbleiterkörpers erfolgen. Der externe elektrische Anschluss kann auf der Seite der Anschlussfläche erfolgen. Die Anschlussflächen können, da die Stromverteilung über die Oberfläche des Halbleiterkörpers im ersten Kontakt und insbesondere auch die elektrische Kontaktbildung zum Halbleiterkörpers mittels des ersten und/oder des zweiten Kontakts auf der anderen Seite des Halbleiterkörpers bzw. von dieser Seite her erfolgen, vereinfacht vorteilhaft kleinflächig ausgeführt werden. Übermäßige Absorptionsverluste können so vermieden werden. Die Anschlussflächen sind zweckmäßigerweise für die Verbindung mit einem Bonddraht, z. B. jeweils mittels einer Bondschicht, wie einer Au-Schicht, ausgeführt. Die Anschlussfläche(n) kann(können) außenseitig entlang des Halbleiterkörpers mit dem auf der anderen Seite des aktiven Bereichs angeordneten Teil des zu der jeweiligen Anschlussfläche gehörigen Kontakts leitend verbunden sein.

In einer weiteren bevorzugten Ausgestaltung weist das optoelektronische Bauelement einen thermischen Anschlussbereich auf. Der thermische Anschlussbereich ist vorzugsweise zur stoffschlüssigen Verbindung mit einem Wärmeleitelement, z. B. einem Wärmeleitkörper, etwa einem Ge-Körper, vorgesehen. Der thermische Anschlussbereich ist vorzugsweise zusätzlich zu den Anschlussflächen für den elektrischen Anschluss vorgesehen. Sind die Anschlussflächen auf der gleichen Seite des aktiven Bereichs angeordnet, so ist der thermische Anschlussbereich vorzugsweise auf der von dieser Seite abgewandten Seite des aktiven Bereichs angeordnet. Der thermische Anschlussbereich kann mittels eines Bereichs eines der Kontakte, welcher nach außen hin freiliegt, gebildet sein. Der thermische Anschlussbereich kann auf der vom aktiven Bereich abgewandten Seite der Reflektorschicht, der Kontaktschicht des ersten Kontakts und/oder der dielektrischen Spiegelschicht angeordnet sein.

In einer weiteren bevorzugten Ausgestaltung sind die Anschlussflächen der beiden Kontakte auf verschiedenen Seiten des aktiven Bereichs angeordnet. Der aktive Bereich und insbesondere der Halbleiterkörper kann zwischen den Anschlussflächen angeordnet sein. In diesem Falle ist bevorzugt die Anschlussfläche des einen Kontakts für eine Drahtverbindung und die Anschlussfläche des anderen Kontakts für eine elektrisch leitende Schichtverbindung zu einem der jeweiligen Anschlussfläche zugeordneten elektrischen Anschlussleiter ausgebildet.

In einer weiteren bevorzugten Ausgestaltung weist einer der Kontakte eine Kontaktdurchführung von der einen Seite des Halbleiterkörpers auf die dieser Seite vom aktiven Bereich aus gesehen gegenüberliegende Seite des Halbleiterkörpers auf. Die Kontaktdurchführung kann sich durch den gesamten Halbleiterkörper oder lateral neben einer den Halbleiterkörper begrenzenden Seitenfläche erstrecken. Die Kontaktdurchführung erstreckt sich zweckmäßigerweise entlang des gesamten Halbleiterkörpers. Insbesondere erstreckt sich die Kontaktdurchführung von der einen Seite des aktiven Bereichs auf die andere Seite des aktiven Bereichs.

Mittels dieser Kontaktdurchführung kann die Anschlussfläche eines Kontakts, die z.B. auf der von der Kontaktschicht des ersten Kontakts, von der Reflektorschicht, von dem Stromaufweitungsbereich und/oder von der dielektrischen Spiegelschicht abgewandten Seite des Halbleiterkörpers angeordnet ist, elektrisch leitend mit dem Teil dieses Kontakts verbunden sein, der auf der von dieser Anschlussfläche abgewandten Seite des Halbleiterkörpers angeordnet ist.

In einer weiteren bevorzugten Ausgestaltung weist ein Kontakt des Bauelements, vorzugsweise weisen beide Kontakte des Bauelements, zumindest zwei Anschlussflächen auf. Zwei Anschlussflächen dieses Kontakts sind bevorzugt auf verschiedenen Seiten des Halbleiterkörpers und insbesondere des aktiven Bereichs angeordnet. Die Freiheitsgrade für den externen elektrischen Anschluss sind so vorteilhaft erhöht.

In einer weiteren bevorzugten Ausgestaltung ist das Bauelement ein strahlungsemittierendes Bauelement, insbesondere ein Lumineszenzdiodenbauelement. Vorzugsweise ist das Bauelement zur Erzeugung und insbesondere zur Auskopplung inkohärenter Strahlung ausgebildet.

In einer weiteren bevorzugten Ausgestaltung ist der Halbleiterkörper des Bauelements epitaktisch gewachsen. Die Halbleiterschichten für den Halbleiterkörper können auf einem Aufwachssubstrat gewachsen sein.

In einer weiteren bevorzugten Ausgestaltung weist das Bauelement einen Träger auf, auf dem der Halbleiterkörper angeordnet ist. Der Halbleiterkörper kann durch den Träger mechanisch stabilisiert werden. Die Gefahr einer Schädigung des Halbleiterkörpers wird so verringert.

Die Anschlussfläche eines oder beider Kontakte, die Kontaktschicht des ersten Kontakts, die Kontaktschicht des zweiten Kontakts, der Stromaufweitungsbereich, die Reflektorschicht und/oder die dielektrische Spiegelschicht kann auf der von dem Träger abgewandten Seite des Halbleiterkörpers und insbesondere der vom Träger abgewandten Seite des aktiven Bereichs angeordnet sein.

Der Träger kann aus dem Aufwachssubstrat, auf dem die Halbleiterschichtenfolge gewachsen ist, ausgebildet sein.

Der Träger kann jedoch auch vom Aufwachssubstrat verschieden sein. Nach dem Wachsen von Halbleiterschichten für den Halbleiterkörper auf dem Aufwachssubstrat kann das Aufwachssubstrat gedünnt oder bereichsweise oder vollständig entfernt werden. Zweckmäßigerweise wird der Träger vor dem Entfernen des Aufwachssubstrates vorgesehen, um das Halbleitermaterial beim und nach dem Entfernen des Aufwachssubstrats mechanisch zu stabilisieren.

Das Bauelement kann also frei von einem Aufwachssubstrat für die Halbleiterschichten des Halbleiterkörpers sein.

Alternativ kann jedoch auf einen den Halbleiterkörper stabilisierenden Träger verzichtet werden. Das Bauelement kann insbesondere aus epitaktisch gewachsenen Halbleiterschichten des Halbleiterkörpers, den Kontakten und gegebenenfalls weiteren auf den Halbleiterkörper aufgebrachten, vorzugsweise nicht freitragenden Schichten, bestehen. Die Kontakte und/oder die weiteren auf den Halbleiterkörper aufgebrachten Schichten können mittels Abscheiden auf den Halbleiterkörper aufgebracht sein. Beim Abscheiden wächst die Schichtdicke mit der Abscheidezeit.

Das Bauelement kann also als trägerloses Bauelement ausgeführt sein. Auf einen gesondert vorgesehenen, insbesondere freitragenden, Träger zur mechanischen Stabilisierung des Halbleiterkörpers kann verzichtet sein. Für ein trägerloses Bauelement kann beispielsweise das Aufwachssubstrat entfernt sein.

Da auf einen Träger verzichtet wird, kann eine sehr geringe Bauhöhe des Bauelements erreicht werden. Gegenüber Bauelementen mit Träger ist bei der Handhabung derartiger Bauelemente, wie z. B. der Montage, eine erhöhte Sorgfalt erforderlich, um eine Schädigung des Bauelements zu vermeiden.

Das Bauelement ist vorzugsweise als chipartiges Bauelement ausgebildet. Weiterhin kann das Bauelement in Chipgröße ausgeführt sein. Eine laterale Ausdehnung des Bauelements in Aufsicht auf den aktiven Bereich ist gegenüber der lateralen Ausdehnung des aktiven Bereichs bei einem Bauelement in Chipgröße vorteilhaft gering.

Das Verhältnis des Flächeninhalts der vom aktiven Bereich und insbesondere dem Halbleiterkörper überdeckten Fläche zu dem Inhalt der gesamten Fläche, über die sich das Bauelement erstreckt, kann bei dem Bauelement größer als 0,2, bevorzugt größer als 0,3, besonders bevorzugt größer als 0,5, am meisten bevorzugt größer als 0,7 sein.

Das hierin und im Folgenden beschriebene Bauelement kann ferner im Verbund gefertigt werden. Hierbei werden Herstellungsschritte nicht jeweils getrennt für einzelne Bauelemente sondern gleichzeitig an einer Mehrzahl von Bauelementen durchgeführt. Ferner kann bei dem hierin beschriebenen Bauelement auf ein zusätzliches, das Bauelement schützendes Gehäuse, in dem das Bauelement montiert wird und das nicht im Verbund gemeinsam mit dem Bauelement hergestellt wird, verzichtet werden.

Das Bauelement kann insbesondere aus dem Verbund vereinzelt, beispielsweise gesägt, sein. Das Bauelement kann demnach vereinzelte Seitenflächen, also Seitenflächen, die beim Vereinzeln ausgebildet werden, aufweisen.

Eine optoelektronische Vorrichtung umfasst gemäß einer Ausführungsform einen Anschlussträger und ein optoelektronisches Bauelement, insbesondere ein Bauelement der weiter oben und im Folgenden näher beschriebenen Art. Der Anschlussträger weist vorzugsweise zumindest zwei elektrisch voneinander getrennte elektrische Anschlussleiter auf. Das Bauelement ist zweckmäßigerweise auf dem Anschlussträger angeordnet und insbesondere befestigt. Dabei ist die Montageseite des Bauelements dem Anschlussträger bevorzugt zugewandt. Die Kontakte des Bauelements sind bevorzugt elektrisch leitend mit den elektrischen Anschlussleitern verbunden, wobei jedem Kontakt ein gesonderter Anschlussleiter zugeordnet ist. Elektrische Anschlussflächen der Kontakte sind den elektrischen Anschlussleitern zweckmäßigerweise zugewandt. Eine elektrische Anbindung kann über eine stoffschlüssige Verbindung, z. B. eine Lotverbindung, erfolgen, die zwischen der Anschlussfläche des jeweiligen Kontakts und dem dieser zugeordneten Anschlussleiter ausgebildet sein kann.

Zwischen dem Halbleiterkörper des optoelektronischen Bauelements und dem Anschlussträger kann ein elektrisch isolierendes Füllmaterial angeordnet sein. Das Füllmaterial ist bevorzugt im Bereich zwischen den Anschlussflächen angeordnet. Das Füllmaterial kann an den Anschlussträger und das optoelektronische Bauelement angrenzen. Das Füllmaterial kann in einem Bereich vorgesehen sein, in dem die Anschlussflächen sich nicht über den Halbleiterkörper erstrecken. Das Füllmaterial kann das Halbleitermaterial des optoelektronischen Bauelements mechanisch unterstützen. Das Füllmaterial kann an beide Kontakte des Bauelements angrenzen. Für das Füllmaterial eignet sich zum Beispiel eine Formmasse, zum Beispiel ein Epoxidharz. Die Formmasse ist vorzugsweise gehärtet. Die Gefahr einer mechanischen Beschädigung des Bauelements im Betrieb wird so verringert. Von besonderem Vorteil ist das Füllmaterial bei einem Bauelement, das aufwachssubstratlos und insbesondere auch trägerlos ausgeführt ist. Das Bauelement kann in Oberflächenmontagetechnik auf dem Anschlussträger befestigt sein. Der Anschlussträger ist von einem Zwischenträger (submount) vorzugsweise verschieden. Der Anschlussträger kann beispielsweise durch eine Leiterplatte, etwa eine gedruckte Leiterplatte oder eine Metallkernplatine, oder einen Anschlussträger, der eine Keramik enthält und mit elektrisch leitendem Material für die Anschlussleiter versehen ist, gebildet sein.

Weitere Vorteile, Merkmale und Zweckmäßigkeiten der Erfindung ergeben sich aus der folgenden Beschreibung der Ausführungsbeispiele in Verbindung mit den Figuren.
Figur 1 zeigt ein erstes Ausführungsbeispiel eines optoelektronischen Bauelements anhand einer schematischen Aufsicht in Figur 1A, zwei schematischen Schnittansichten in den Figuren 1B und 1C, einer vereinfachten schematischen Schnittansicht in Figur 1D und einer Teilschnittansicht in Figur 1E.
Figur 2 zeigt ein weiteres Ausführungsbeispiel eines optoelektronischen Bauelements anhand einer schematischen Aufsicht in Figur 2A und einer schematischen Schnittansicht in Figur 2B.
Figur 3 zeigt ein weiteres Ausführungsbeispiel eines optoelektronischen Bauelements anhand einer schematischen Schnittansicht.
Figur 4 zeigt ein weiteres Ausführungsbeispiel eines optoelektronischen Bauelements anhand einer schematischen Schnittansicht.
Figur 5 zeigt ein weiteres Ausführungsbeispiel eines optoelektronischen Bauelements anhand einer schematischen Schnittansicht.
Figur 6 zeigt ein weiteres Ausführungsbeispiel eines optoelektronischen Bauelements anhand einer schematischen Schnittansicht.
Figur 7 zeigt ein weiteres Ausführungsbeispiel eines optoelektronischen Bauelements anhand einer schematischen Schnittansicht.
Figur 8 zeigt ein weiteres Ausführungsbeispiel eines optoelektronischen Bauelements anhand einer schematischen Schnittansicht.
Figur 9 zeigt ein Ausführungsbeispiel einer optoelektronischen Vorrichtung anhand einer schematischen Schnittansicht.

Gleiche, gleichartige und gleich wirkende Elemente sind in den Figuren mit gleichen Bezugszeichen versehen.

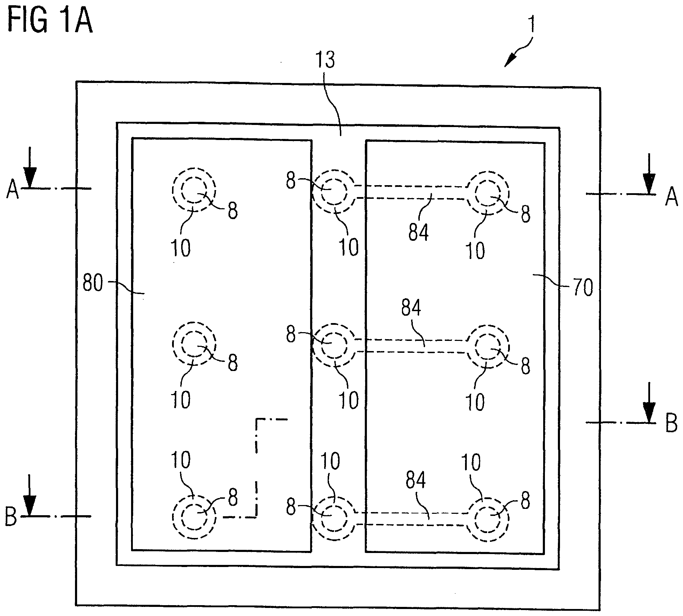

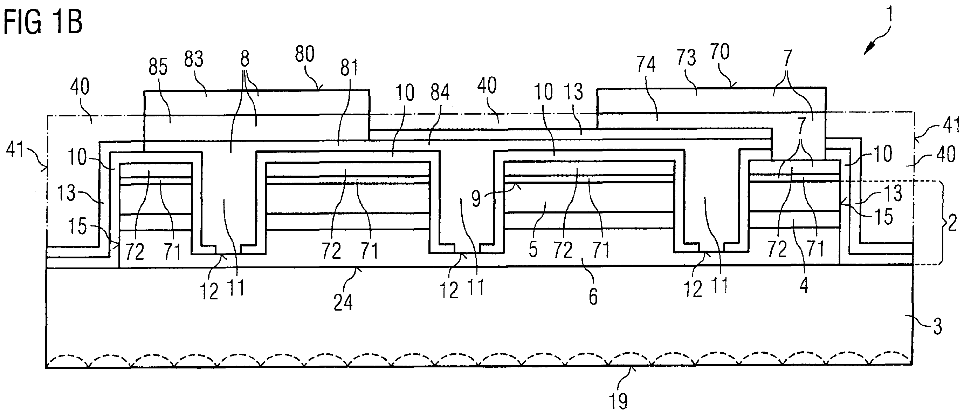

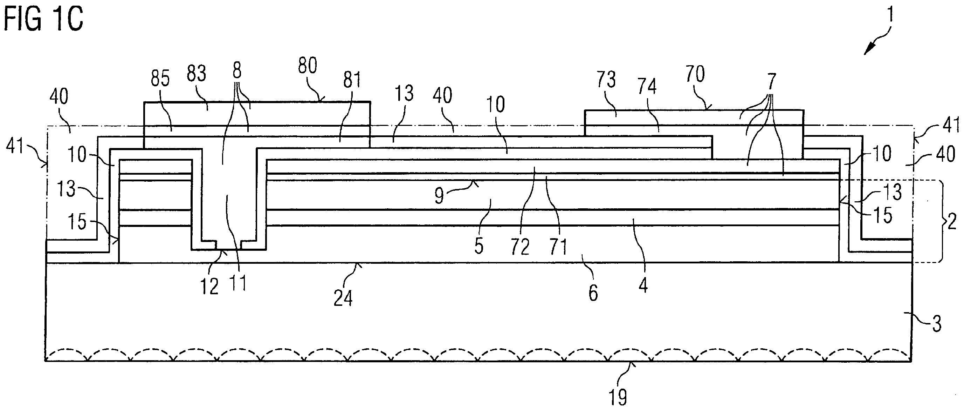

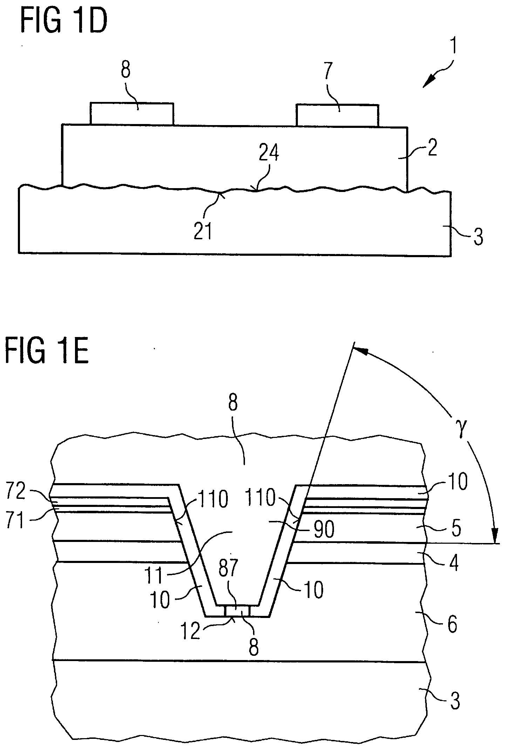

Figur 1 zeigt ein erstes Ausführungsbeispiel eines optoelektronischen Bauelements anhand einer schematischen Aufsicht in Figur 1A, zwei schematischen Schnittansichten in den Figuren 1B und 1C, einer vereinfachten schematischen Schnittansicht in Figur 1D und einer Teilschnittansicht in Figur 1E. Figur 1B entspricht dabei einem Schnitt entlang der Linie A-A in Figur 1A und Figur 1C entspricht einem Schnitt entlang der Linie B-B in Figur 1A.

Das optoelektronische Bauelement 1 weist einen Halbleiterkörper 2 auf. Der Halbleiterkörper ist auf einem Träger 3 angeordnet, den das Bauelement 1 aufweist. Der Halbleiterkörper 2 umfasst eine Halbleiterschichtenfolge mit einem zur Strahlungserzeugung geeigneten aktiven Bereich 4. Die Halbleiterschichtenfolge kann insbesondere eine Mehrzahl von Halbleiterschichten umfassen, zwischen denen der aktive Bereich angeordnet ist. Weiterhin bildet die Halbleiterschichtenfolge bevorzugt den Halbleiterkörper. Der Träger 3 stabilisiert den Halbleiterkörper 2 mit Vorzug mechanisch.

Der Halbleiterkörper 2 ist bevorzugt als Lumineszenzdioden-Halbleiterkörper ausgebildet. Der Halbleiterkörper umfasst bevorzugt zwei Bereiche 5, 6 mit unterschiedlichen Leitungstypen (n-leitend oder p-leitend). Zwischen diesen Bereichen 5 und 6 ist zweckmäßigerweise der aktive Bereich 4 angeordnet oder ausgebildet. Der Bereich 5 und/oder 6 kann eine Mehrzahl von Halbleiterschichten aufweisen.

Der aktive Bereich 4 umfasst bevorzugt eine Heterostruktur, insbesondere eine Doppelheterostruktur, oder eine Quantenstruktur, besonders bevorzugt eine Ein- oder Mehrfach-Quantentopfstruktur, eine Quantendrahtstruktur oder eine Quantenpunktstruktur. Derartige Strukturen zeichnen sich durch besonders hohe interne Quanteneffizienzen bei der Strahlungserzeugung im aktiven Bereich aus.

Die Halbleiterschichtenfolge ist bevorzugt epitaktisch auf einem Aufwachssubstrat gewachsen. Bevorzugt ist der gesamte Halbleiterkörper epitaktisch gewachsen.

Der Träger 3 kann beim Herstellen des Bauelements 1 aus dem Aufwachssubstrat ausgebildet sein oder vom Aufwachssubstrat verschieden sein. Im letzteren Fall wird der Träger 3 oder Material, aus dem der Träger ausgebildet wird, bevorzugt auf das gewachsene Halbleitermaterial aufgebracht, bevor das Aufwachssubstrat von dem gewachsenen Halbleitermaterial bereichsweise oder vollständig entfernt wird. Eine mechanische Stabilisierung des gewachsenen Halbleitermaterials ist durch den Träger 3 auch bei einem entfernten Aufwachssubstrat gegeben. Ist der Träger 3 vom Aufwachssubstrat verschieden, so kann der Träger als harter Trägerkörper mit dem gewachsenen Halbleitermaterial verbunden werden oder es kann zunächst eine Formmasse auf den Halbleiterkörper aufgebracht werden, welche nachfolgend für die Ausbildung eines Trägers gehärtet wird. Für eine derartige Formmasse eignet sich beispielsweise BCB (Benzo-Cyclo-Buten). Als harter Trägerkörper eignet sich beispielsweise ein Glas.

Der Träger 3 ist vorzugsweise strahlungsdurchlässig für im aktiven Bereich 4 zu erzeugende Strahlung ausgebildet, sodass die Strahlung aus dem Halbleiterkörper in den Träger eintreten und nachfolgend über den Träger aus dem Bauelement 1 auskoppeln kann.

In einer bevorzugten Ausgestaltung enthält die Halbleiterschichtenfolge, insbesondere die Bereiche 5 und 6 des Halbleiterkörpers und/oder der aktive Bereich 4, ein III-V-Halbleitermaterial. Mittels III-V-Verbindungshalbleitermaterialien, insbesondere Nitrid-Verbindungshalbleitermaterialien, Phosphid-Verbindungshalbleitermaterialien oder Arsenid-Verbindungshalbleitermaterialien, können bei der Strahlungserzeugung vereinfacht hohe interne Quanteneffizienzen bei der Umwandlung von elektrischer Leistung in Strahlungsleistung erzielt werden. Bevorzugt basiert der aktive Bereich und insbesondere der Halbleiterkörper daher auf einem der genannten Materialsysteme.

"Auf Phosphid-Verbindungshalbleitern basierend" bedeutet in diesem Zusammenhang, dass der aktive Bereich, insbesondere der Halbleiterkörper, vorzugsweise AlₙGaₘIn₁₋ₙ₋ₘP umfasst oder daraus besteht, wobei 0 ≤ n ≤ 1, 0 ≤ mm 1 und n+m ≤ 1 ist, vorzugsweise mit n ≠ 0, n ≠ 1, m ≠ 0 und/oder m ≠ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die physikalischen Eigenschaften des Materials im Wesentlichen nicht ändern. Der Einfachheit halber beinhaltet obige Formel jedoch nur die wesentlichen Bestandteile des Kristallgitters (Al, Ga, In, P), auch wenn diese teilweise durch geringe Mengen weiterer Stoffe ersetzt sein können.

"Auf Nitrid-Verbindungshalbleitern basierend" bedeutet in diesem Zusammenhang, dass der aktive Bereich, insbesondere der Halbleiterkörper, vorzugsweise AlₙGaₘIn₁₋ₙ₋ₘN umfasst oder daraus besteht, wobei 0 ≤ n ≤ 1, 0 ≤ m ≤ 1 und n+m ≤ 1 ist, vorzugsweise mit n ≠ 0, n ≠ 1, m ≠ 0 und/oder m ≠ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die physikalischen Eigenschaften des Materials im Wesentlichen nicht ändern. Der Einfachheit halber beinhaltet obige Formel jedoch nur die wesentlichen Bestandteile des Kristallgitters (Al, Ga, In, N), auch wenn diese teilweise durch geringe Mengen weiterer Stoffe ersetzt sein können.

"Auf Arsenid-Verbindungshalbleitern basierend" bedeutet in diesem Zusammenhang, dass der aktive Bereich, insbesondere der Halbleiterkörper, vorzugsweise AlₙGaₘIn₁₋ₙ₋ₘAs umfasst oder daraus besteht, wobei 0 ≤ n ≤ 1, 0 ≤ m ≤ 1 und n+m ≤ 1 ist, vorzugsweise mit n ≠ 0, n ≠ 1, m ≠ 0 und/oder m ≠ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die physikalischen Eigenschaften des Materials im Wesentlichen nicht ändern. Der Einfachheit halber beinhaltet obige Formel jedoch nur die wesentlichen Bestandteile des Kristallgitters (Al, Ga, In, As), auch wenn diese teilweise durch geringe Mengen weiterer Stoffe ersetzt sein können.

Als Aufwachssubstrat ist für Nitrid-Verbindungshalbleiter z.B. ein Saphir-, SiC- oder GaN-Aufwachssubstrat, für Phosphid- und Arsenid-Verbindungshalbleiter ist beispielsweise ein GaAs-Aufwachssubstrat geeignet.

Nitrid- und Phosphid-Verbindungshalbleitermaterialien sind für die Erzeugung sichtbarer Strahlung besonders geeignet. Arsenid-Verbindungshalbleitermaterialien sind für den infraroten Spektralbereich besonders geeignet. Nitrid-Verbindungshalbleitermaterialien eignen sich dabei besonders für die Erzeugung von Strahlung vom ultravioletten über den blauen bis in den grünen Spektralbereich und Phosphid-Verbindungshalbleitermaterialien für Strahlung vom orangen bis in den roten Spektralbereich.

Bevorzugt ist das Bauelement 1 und insbesondere dessen aktiver Bereich 4 zur Erzeugung sichtbarer Strahlung ausgebildet. Weiterhin ist das Bauelement vorzugsweise als LED-Bauelement zur Abstrahlung inkohärenter Strahlung ausgebildet.

Das optoelektronische Bauelement 1 weist zwei elektrische Kontakte, einen ersten Kontakt 7 und einen zweiten Kontakt 8, auf. Die Kontakte 7 und 8 sind mit dem Halbleiterkörper 2 auf verschiedenen Seiten des aktiven Bereichs 4 elektrisch leitend verbunden. Beispielsweise ist der erste Kontakt 7 mit dem Bereich 5 des Halbleiterkörpers elektrisch leitend verbunden und der zweite Kontakt 8 ist mit dem Bereich 6 elektrisch leitend verbunden. Über die Kontakte 7 und 8 können im Betrieb des Bauelements Ladungsträger in den aktiven Bereich 4 injiziert werden. Diese können dort unter Strahlungserzeugung rekombinieren.

Die beiden Kontakte 7, 8 erstrecken sich bereichsweise über eine gemeinsame Hauptfläche 9 des Halbleiterkörpers. Die Hauptfläche 9 ist insbesondere zwischen beiden Kontakten und dem aktiven Bereich angeordnet. Die Kontakte 7 und 8 sind im vorliegenden Ausführungsbeispiel auf der vom Träger 3 abgewandten Seite des Halbleiterkörpers 2 angeordnet.

Der erste Kontakt 7 ist mit dem aktiven Bereich 4 über die Hauptfläche 9 des Halbleiterkörpers und der zweite Kontakt 8 ist mit dem Halbleiterkörper auf der von der Hauptfläche 9 abgewandten Seite des aktiven Bereichs 4 elektrisch leitend verbunden.

Der erste Kontakt 7 umfasst bevorzugt eine Kontaktschicht 71. Diese ist, insbesondere direkt, über die Hauptfläche 9 des Halbleiterkörpers 2 mit dem Halbleiterkörper und damit dem aktiven Bereich 4 elektrisch leitend verbunden.

Die Kontaktschicht 71 überdeckt mit Vorteil einen großen Teil der Hauptfläche 9 des Halbleiterkörpers 2, so dass über die Kontaktschicht 71 großflächig und homogen Ladungsträger in den Halbleiterkörper 2 injiziert werden können. Die Kontaktschicht erstreckt sich zweckmäßigerweise großflächig über die zwischen dem aktiven Bereich 4 und der Kontaktschicht angeordnete Hauptfläche 9 des Halbleiterkörpers. Beispielsweise erstreckt sich die Kontaktschicht über 80% oder mehr bevorzugt 90% oder mehr, besonders bevorzugt 95% oder mehr der der Kontaktschicht 71 zugewandten Hauptfläche 9 des Halbleiterkörpers. Mit Vorzug bedeckt die Kontaktschicht 71 die Hauptfläche 9 zu den oben angegeben Prozentwerten.

Die Kontaktschicht kann eine Dicke von 50 nm oder weniger, bevorzugt von 30 nm oder weniger, besonders bevorzugt von 20 nm oder weniger, beispielsweise 10 nm oder weniger aufweisen.

Auf dem Halbleiterkörper, insbesondere auf der Hauptfläche 9, ist eine Reflektorschicht 72 angeordnet. Der erste Kontakt 7 umfasst bevorzugt die Reflektorschicht 72. Die Reflektorschicht ist zweckmäßigerweise auf der vom Halbleiterkörper 2 abgewandten Seite der Kontaktschicht 71 angeordnet. Die Reflektorschicht 72 erstreckt sich bevorzugt großflächig, besonders bevorzugt entsprechend der Kontaktschicht 71, über die Hauptfläche 9 des Halbleiterkörpers 2.

Die Reflektorschicht weist für die im aktiven Bereich erzeugte Strahlung zweckmäßigerweise eine Reflektivität von 80% oder mehr, bevorzugt von 90% oder mehr, besonders bevorzugt von 95% oder mehr auf.

Die Reflektorschicht 72 kann eine Dicke von 80 nm oder mehr, bevorzugt 100 nm oder mehr, besonders bevorzugt 200 nm oder mehr aufweisen.

Der zweite Kontakt 8 weist weiterhin einen
Stromaufweitungsbereich 81 auf. Mittels des
Stromaufweitungsbereichs 81 können Ladungsträger großflächig über die Erstreckungsrichtung des aktiven Bereichs 4 verteilt werden. Bevorzugt weist der Stromaufweitungsbereich 81 einen oder eine Mehrzahl von Kontaktfortsätzen 84 auf, die sich über den Halbleiterkörper erstreckt. Der jeweilige Kontaktfortsatz verläuft bevorzugt bahnenartig über die Hauptfläche 9 des Halbleiterkörpers 2. Der
Stromaufweitungsbereich 81 des zweiten Kontakts 8 ist bevorzugt auf der vom aktiven Bereich 4 abgewandten Seite der Kontaktschicht 71 beziehungsweise der Reflektorschicht 72 angeordnet.

Die Kontakte 7, 8 weisen jeweils eine Anschlussfläche 70 bzw. 80 auf. Die Anschlussflächen sind jeweils vom Halbleiterkörper 2 abgewandt. Figur 1A zeigt eine Aufsicht auf die Anschlussflächen 70, 80. Bevorzugt weisen die Kontakte 7 und/oder 8 jeweils genau eine Anschlussfläche auf.

Ein Teilbereich des ersten Kontakts 7, insbesondere die Kontaktschicht 71 bzw. die Reflektorschicht 72, ist zwischen dem zweiten Kontakt 8, insbesondere der Anschlussfläche 80 des zweiten Kontakts und/oder dem Stromaufweitungsbereich 81 des zweiten Kontakts, und der Hauptfläche 9 des Halbleiterkörpers 2 angeordnet.

Um einen Kurschluss zu vermeiden, sind die beiden Kontakte zweckmäßigerweise über eine Isolationsschicht 10, die zwischen den beiden Kontakten angeordnet ist, elektrisch voneinander isoliert. Die Isolationsschicht 10 verläuft zweckmäßigerweise in dem Bereich zwischen den Kontakten, in dem der erste Kontakt 7 zwischen dem Halbleiterkörper 2 und dem zweiten Kontakt 8 angeordnet ist.

Weiterhin ist ein Teilbereich des zweiten Kontakts 8 zwischen dem ersten Kontakt 7 und dem Halbleiterkörper 2, insbesondere zwischen dem ersten Kontakt 7 und der Hauptfläche 9 des Halbleiterkörpers, angeordnet. Der Stromaufweitungsbereich 81 kann sich z.B. zwischen dem ersten Kontakt 7, insbesondere dessen Anschlussfläche 70, und dem Halbleiterkörper 2 erstrecken. Ein Teilbereich des zweiten Kontakts 8, z. B. der Stromaufweitungsbereich 81, kann vom ersten Kontakt 7 umgeben sein. Beispielsweise kann ein Teilbereich des Stromaufweitungsbereichs 81 des zweiten Kontakts zwischen der Anschlussfläche 70 des ersten Kontakts und der Kontaktschicht 71 und/oder der Reflektorschicht 72 angeordnet sein.

Zwischen dem Bereich des zweiten Kontakts 8, der zwischen dem ersten Kontakt 7 und dem Halbleiterkörper 2 angeordnet ist, ist zweckmäßigerweise eine weitere Isolationsschicht 13 angeordnet, die die beiden Kontakte elektrisch voneinander isoliert. Die Isolationsschicht 13 verläuft zweckmäßigerweise in dem Bereich zwischen den Kontakten, in dem der zweite Kontakt 8 zwischen dem Halbleiterkörper 2 und dem ersten Kontakt 7 angeordnet ist. Die Isolationsschicht 13 ist zweckmäßigerweise auf der vom aktiven Bereich abgewandten Seite der Isolationsschicht 10 angeordnet.

Der zweite Kontakt 8 kann demnach beidseitig, also auf der der Hauptfläche 9 zugewandten Seite und auf der vom Halbleiterkörper 2 abgewandten Seite mit einer Isolationsschicht - den Schichten 10 beziehungsweise 13 - bedeckt sein. Insbesondere kann der zweite Kontakt 8 in diesem Bereich in Isolationsmaterial eingebettet sein. Die Isolationsschichten 10, 13 können bereichsweise aneinander angrenzen (vgl. Figur 1C). Die bahnartig verlaufenden Kontaktfortsätze 84 können aufgrund der beidseitigen Isolierung nahezu beliebig verteilt über den Halbleiterkörper geführt werden.

Die Kontakte sind bevorzugt von der Hauptfläche 9 bis zu der von dieser Fläche abgewandten Seite des aktiven Bereichs 3 elektrisch voneinander isoliert.

Die Isolationsschicht 10 und/oder die Isolationsschicht 13 kann zwischen der Anschlussfläche 70 des ersten Kontakts 7 und dem Halbleiterkörper 2, insbesondere zwischen der Anschlussfläche 70 des ersten Kontakts und der Kontaktschicht 71 beziehungsweise der Reflektorschicht 72, angeordnet sein. Die Isolationsschicht 10 ist mit Vorzug in einem Teilbereich zwischen der Anschlussfläche 80 und dem Halbleiterkörper, insbesondere zwischen der Anschlussfläche 80 und der Kontaktschicht 71 beziehungsweise der Reflektorschicht 72, angeordnet.

Der jeweilige Kontaktfortsatz 84 erstreckt sich bevorzugt von der Anschlussfläche 80 des zweiten Kontakts 8 weg. Bevorzugt erstreckt sich der jeweilige Kontaktfortsatz 84 von der Anschlussfläche 80 weg über die Oberfläche 9.

Die Kontaktschicht 71 und/oder die Reflektorschicht 72 erstreckt sich von der Anschlussfläche des einen Kontakts bis unter die Anschlussfläche des anderen Kontakts.

Der zweite Kontakt 8 erstreckt sich von der vom aktiven Bereich 4 abgewandten Seite des ersten Kontakts 3 bzw. der Reflektorschicht 72 ausgehend bis zu der von der Hauptfläche 9 abgewandten Seite des aktiven Bereichs 4 und ist auf dieser Seite elektrisch leitend mit dem Halbleiterkörper verbunden.

Mit Vorteil können so die Stromaufweitung im zweiten Kontakt und die Kontaktbildung zum Halbleiterkörper mittels des ersten Kontakts 7 auf der gleichen Seite des aktiven Bereichs 4 erfolgen. Insbesondere kann die Stromaufweitung auf der vom Halbleiterkörper abgewandten Seite der Reflektorschicht erzielt werden, so dass einer Absorption von Strahlung im Bereich des zweiten Kontakts 8, welcher, wie etwa der Stromaufweitungsbereich 81, auf der vom aktiven Bereich 4 abgewandten Seite des ersten Kontakts 7 verläuft, vorgebeugt werden kann.

Für den Durchtritt des zweiten Kontakts 8 auf die andere Seite des aktiven Bereichs - also auf die von der Hauptfläche 9, dem Stromaufweitungsbereich 81, der Anschlussfläche 70 bzw. 80, der Kontaktschicht 71 bzw. der Reflektorschicht 72 abgewandte Seite des aktiven Bereichs - ist der aktive Bereich, insbesondere mehrfach, durchbrochen. Der aktive Bereich ist hierzu zweckmäßigerweise geeignet ausgespart. Der jeweilige Durchbruch ist vorzugsweise lateral umfangsseitig vom Halbleiterkörper begrenzt. Beispielsweise ist für die Durchbrüche eine Mehrzahl von Ausnehmungen 11 im Halbleiterkörper vorgesehen, welche sich von der Hauptfläche 9 aus ausgehend in den Halbleiterkörper und durch den aktiven Bereich erstrecken.

Der zweite Kontakt 8 ist im Bereich des Durchbruchs vom aktiven Bereich elektrisch isoliert, um einen Kurzschluss zu vermeiden. Bevorzugt ist der Durchbruch und insbesondere die Ausnehmung mit einem Isolationsmaterial ausgekleidet. Die Isolationsschicht 10 kann sich hierzu entlang des Durchbruchs und insbesondere entlang der Ausnehmung 11 erstrecken.

Der Durchbruch und insbesondere die Ausnehmung ist weiterhin zweckmäßigerweise mit Kontaktmaterial für den zweiten Kontakt befüllt.

Einer oder eine Mehrzahl von Durchbrüchen bzw. Ausnehmungen ist vorzugsweise von der Anschlussfläche 70, der Anschlussfläche 80, der Kontaktschicht 71, der Reflektorschicht 72 und/oder dem Stromaufweitungsbereich 81 überdeckt (vergleiche die Aufsicht in Figur 1A).

Ein oder eine Mehrzahl von Kontaktfortsätzen 84 kann sich über eine Mehrzahl von Durchbrüchen bzw. Ausnehmungen erstrecken. Von dem Stromaufweitungsbereich, insbesondere von einem Kontaktfortsatz, können durch den Durchbruch erstreckende Bereiche des Kontakts abzweigen.

Der Stromaufweitungsbereich 81, insbesondere einer oder eine Mehrzahl von Kontaktfortsätzen 84, erstreckt sich vorzugsweise großräumig über die Hauptfläche 9. Der Stromaufweitungsbereich, insbesondere einer oder eine Mehrzahl von Kontaktfortsätzen, kann sich über 50 % oder mehr, bevorzugt 60 % oder mehr, besonders bevorzugt 70 % oder mehr, am meisten bevorzugt 80 % oder mehr, z.B. 90 % oder mehr, einer Längsabmessung des Halbleiterkörpers, z.B. die Länge, und/oder einer Querabmessung des Halbleiterkörpers, z.B. die Breite, erstrecken.

Über eine Mehrzahl gesonderter Kontaktstellen 12 ist der zweite Kontakt 8 mit dem Halbleiterkörper auf der von der Hauptfläche 9 abgewandten Seite des aktiven Bereichs elektrisch leitend verbunden. Die elektrische Isolierung des zweiten Kontakts vom Halbleiterkörper - z.B. die Isolationsschicht 10 - ist für die Kontaktbildung in dem Bereich der Kontaktstelle zweckmäßigerweise ausgespart. Die Kontaktstellen 12 sind vorzugsweise unmittelbar am Boden der Ausnehmungen 11 gebildet.

Die Isolationsschicht 10 und gegebenenfalls die weitere Isolationsschicht 13 erstreckt sich mit Vorzug von der Hauptfläche 9 ausgehend entlang von Seitenflächen 15, die den aktiven Bereich 4 und insbesondere den Halbleiterkörper 2 lateral begrenzen. Die jeweilige Isolationsschicht kann als Schutzschicht für die Seitenflächen des Halbleiterkörpers dienen.

Die Isolationsschicht 10 bzw. 13 enthält z.B. ein Siliziumnitrid, wie SiN, ein Siliziumoxid, wie SiO₂, oder ein Siliziumoxinitrid, wie SiON.

Für den Durchtritt des zweiten Kontakts 8 ist die Kontaktschicht 71 und/oder die Reflektorschicht 72 vorzugsweise ausgespart. Abgesehen von den Aussparungen für den Kontaktdurchtritt des zweiten Kontakts 8 ist die Kontaktschicht 71 und/oder die Reflektorschicht 72 vorzugsweise durchgehend ausgeführt. Die Kontaktschicht und/ oder die Reflektorschicht kann abgesehen von den für den Durchtritt des zweiten Kontakts 8 ausgesparten Bereichen die gesamte Hauptfläche 9 des Halbleiterkörpers 2 bedecken.

Eine derartige Kontaktstruktur erleichtert es - trotz der Anordnung der Anschlussflächen 70 und 80 auf der gleichen Seite des aktiven Bereichs und insbesondere über der gleichen Fläche des Halbleiterkörpers - eine beidseitig homogene und großflächige Ladungsträgerinjektion in den aktiven Bereich 4 zu erzielen. Die Effizienz des Bauelements bei der Strahlungserzeugung wird so erhöht. Von der einen Seite des aktiven Bereichs, die der Kontaktschicht zugewandt ist, können Ladungsträger über die Kontaktschicht großflächig in den Halbleiterkörper gelangen und zum aktiven Bereich geleitet werden. Von der anderen Seite des aktiven Bereichs können über den zweiten Kontakt, insbesondere die Kontaktstellen, in den Halbleiterkörper injizierte Ladungsträger zu dem aktiven Bereich gelangen.

Über die Reflektorschicht 72 kann einer Absorption von Strahlung in auf der von dem aktiven Bereich 4 abgewandten Seite der Reflektorschicht angeordneten Strukturen, beispielsweise Leiterbahnen einer Leiterplatte, auf der das Bauelement montiert wird, vorgebeugt werden.

Weiterhin kann mittels der Reflektorschicht 72 im aktiven Bereich 4 erzeugte Strahlung zu einer Auskoppelfläche 19 des Bauelements gelenkt werden. Die Auskoppelfläche ist mit Vorteil mittels einer von der Hauptfläche 9 verschiedenen Oberfläche des Bauelements gebildet. Beispielsweise kann die vom Halbleiterkörper 2 abgewandte Oberfläche des Trägers 3 die Auskoppelfläche 19 bilden.

Da Stromaufweitung im einen Kontakt und Kontaktbildung zum Halbleiterkörper mittels des anderen Kontakts auf einer Seite des aktiven Bereichs erfolgen können, sind mit Vorteil die anderen Seiten des Bauelements frei von absorbierenden Elementen, so dass die Auskoppeleffizienz des Bauelements, also das Verhältnis von im aktiven Bereich erzeugter zu aus dem Bauelement austretender Strahlungsleistung, weitergehend erhöht ist.

Die Anschlussflächen 70, 80 der beiden Kontakte sind weiterhin auf der gleichen Seite des Halbleiterkörpers und insbesondere auf der gleichen Seite des aktiven Bereichs 4 - der Anschlussseite des Bauelements 1 - angeordnet. Die Anschlussseite des Bauelements ist bevorzugt auf der dem Träger 3 abgewandten Seite des Halbleiterkörpers 2 ausgebildet. Figur 1A zeigt eine Aufsicht auf die Anschlussseite des Bauelements.

Die Anschlussflächen 70 und 80 sind lateral nebeneinander auf der Hauptfläche 9 angeordnet. Die Kontakte 7 und 8 können insbesondere auf diese Oberfläche des Halbleiterkörpers 2 aufgebracht sein.

Die Anschlussflächen 70, 80 sind vorzugsweise zur elektrisch leitenden Verbindung des optoelektronischen Bauelements mit Anschlussleitern eines externen Anschlussträgers, z. B. Leiterbahnen einer Leiterplatte, vorgesehen.

Besonders bevorzugt sind die Anschlussflächen 70 und 80 der Kontakte dem Anschlussträger bei der Montage des Bauelements auf dem Anschlussträger zugewandt. Die Anschlussseite des Bauelements kann also zugleich die Montageseite des Bauelements für die Montage auf dem Anschlussträger (nicht explizit dargestellt) bilden. Das Bauelement kann somit als flip-chip-artiges Bauelement ausgebildet sein.

Weiterhin liegen die Anschlussflächen 70, 80 vorzugsweise in einer gemeinsamen Ebene. Das Verbinden der Anschlussflächen mit externen Anschlussleitern wird so erleichtert. Die Anschlussflächen der Bauelemente können so vereinfacht über eine elektrisch leitfähige Verbindungsschicht, z. B. mittels eines elektrisch leitfähigen Klebstoffs oder eines Lots, flip-chip-artig mit externen Anschlussleitern elektrisch leitend verbunden werden.

Alternativ kann eine der Anschlussflächen oder es können beide Anschlussflächen für eine Drahtbondverbindung ausgebildet sein. In diesem Falle ist die Montageseite des Bauelements auf dem Anschlussträger zweckmäßigerweise die den Anschlussflächen abgewandte Seite.

Die Reflektorschicht 72 enthält bevorzugt ein Metall, z.B. Al, Ag oder Au, oder eine Legierung, mit Vorzug eine Legierung mit zumindest einem der genannten Materialien, wie etwa AuSn oder AuGe, oder besteht hieraus. Metalle oder metallbasierte Legierungen zeichnen sich durch vorteilhaft hohe Reflektivitäten aus. Für eine Reflektorschicht ist Au, insbesondere für aktive Bereiche auf Phosphid-Verbindungshalbleiterbasis, oder Al oder Ag, insbesondere für aktive Bereiche auf Nitrid-Verbindungshalbleiterbasis, besonders geeignet.

Die Kontakte 7, 8 können beispielsweise unter Abscheiden von Material für die Kontakte auf die Hauptfläche 9 des Halbleiterkörpers 2 ausgebildet sein.

Das Abscheiden von Schichten auf den Halbleiterkörper, wie zum Beispiel Schichten für den jeweiligen Kontakt, der Isolationsschicht(en) und/oder der Reflektorschicht, kann mittels eines galvanischen Verfahrens, eines PVD- oder CVD-Verfahrens, etwa über Sputtern, Aufdampfen oder reaktives Sputtern, erfolgen (PVD: Physical Vapor Deposition; CVD: Chemical Vapor Deposition).

Die Kontakte sind bevorzugt auf Metallbasis ausgebildet. Die Kontakte können insbesondere eine metallbasierte Legierung, z.B. AuSn oder AuZn, oder ein Metall, z.B. Au, Al, Ag, Pt oder Ti, enthalten und insbesondere aus einer oder einer Mehrzahl von metallbasierten Legierungen und/oder einem oder einer Mehrzahl von Metallen bestehen.

Der erste Kontakt 7 weist seitens der Anschlussfläche 70 bevorzugt eine Anschlussschicht 73, besonders bevorzugt eine Lotschicht, z. B. eine Zinn- oder eine Gold-Zinn-Lotschicht, oder eine Bondschicht, z.B. eine Au-Schicht, auf. Der zweite Kontakt 8 weist anschlussseitig bevorzugt eine Anschlussschicht 83, vorzugsweise eine Lotschicht, beispielsweise eine Zinn- oder eine Gold-Zinn-Lotschicht, oder eine Bondschicht, z.B. eine Au-Schicht, auf. Die vom Halbleiterkörper 2 abgewandte Oberfläche der Anschlussschichten 73 und 83 bildet bevorzugt die Anschlussfläche des jeweiligen Kontakts. Eine Bondschicht ist zweckmäßigerweise für die elektrisch leitende Verbindung mit einem Bonddraht vorgesehen und insbesondere ausgebildet.

Die Anschlussfläche 70 des ersten Kontakts 7 ist bevorzugt über eine weitere Schicht 74 des ersten Kontakts elektrisch leitend mit der Kontaktschicht 71 verbunden. Die Anschlussfläche 80 des zweiten Kontakts 8 ist bevorzugt über eine weitere Schicht 85 des zweiten Kontakts elektrisch leitend mit dem Stromaufweitungsbereich verbunden.

Über die Kontaktschicht 71 können Ladungsträger großflächig in den Halbleiterkörper injiziert werden. Eine metallhaltige Kontaktschicht 71 kann zwar bereits ein vergleichsweise großes Reflexionsvermögen für die im aktiven Bereich zu erzeugende Strahlung zeigen. Es ist jedoch von Vorteil, eine gesonderte Reflektorschicht vorzusehen, da die jeweilige Schicht dann auf die jeweilige Funktion hin optimiert werden kann. Die Kontaktschicht 71 kann also zur elektrischen Kontaktbildung zum Halbleiterkörper optimiert werden, während die Reflektorschicht hinsichtlich hoher Reflektivität für die im aktiven Bereich zu erzeugende Strahlung ausgebildet werden kann. Auf elektrische Kontakteigenschaften der Reflektorschicht zum Halbleitermaterial muss nicht geachtet werden.

Die Kontaktschicht kann semitransparent ausgeführt sein. Ist ein absorbierendes Material besonders vorteilhaft für die elektrische Kontaktbildung zum Halbleiterkörper, so ist eine semitransparente Ausführung der Kontaktschicht aufgrund der maßvollen Absorptionsverluste besonders zweckmäßig.

Bei Nitrid-Verbindungshalbleitermaterialien eignet sich beispielsweise Pt besonders für eine Kontaktschicht 71 zu p-leitendem Halbleitermaterial und Al hinsichtlich hoher Reflektivität für die Reflektorschicht 72.

P-leitende Nitrid-Materialien, insbesondere p-GaN, zeigen oftmals eine geringe Leitfähigkeit in lateraler Richtung. Daher ist es von Vorteil, Ladungsträger bereits großflächig in den Halbleiterkörper zu injizieren anstatt auf Stromaufweitung im Halbleiterkörper 2 für eine großflächige Ladungsträgerinjektion in den aktiven Bereich zu setzen.

Die lokalen Kontaktstellen 12 sind zweckmäßigerweise über die Ausdehnung des Halbleiterkörpers verteilt. Vorzugsweise sind die Kontaktstellen gleichmäßig in einem Raster, beispielsweise gitterpunktartig, verteilt. Über die Kontaktstellen können so lateral über den Halbleiterkörper verteilt Ladungsträger lokal in den Halbleiterkörper gelangen. Zweckmäßigerweise weist das Halbleitermaterial des Halbleiterkörpers, welches über den zweiten Kontakt 8 kontaktiert wird, eine höhere Leitfähigkeit in lateraler Richtung - also parallel zum aktiven Bereich - auf als das Material, welches mit dem ersten Kontakt 7 kontaktiert wird. Trotz der nur stellenweisen Kontaktierung des Halbleiterkörpers 2 über den zweiten Kontakt 8 kann so über interne Stromaufweitung im Halbleiterkörper eine homogene Stromverteilung im Halbleiterkörper in lateraler Richtung erreicht werden. Eine großflächige und homogene Ladungsträgerinjektion in den aktiven Bereich kann so vereinfacht trotz der lokalen Ladungsträgerinjektion erreicht werden.

Die Verteilung der Kontaktstellen 12 über den Halbleiterkörper ist vorzugsweise derart auf die Leitfähigkeit in lateraler Richtung des in der jeweiligen Kontaktstelle kontaktierten Halbleitermaterials abgestimmt, dass über Stromaufweitung im Halbleiterkörper die Ladungsträger über die Kontaktstellen 12 in den Halbleiterkörper injiziert und noch vor dem Eintritt in den aktiven Bereich 4 lateral homogen verteilt werden können.

Zweckmäßigerweise ist alternativ oder ergänzend ein Abstand der Kontaktsstellen vom aktiven Bereich derart gewählt, dass über Stromaufweitung im Halbleiterkörper die Ladungsträger über die Kontaktstellen 12 in den Halbleiterkörper injiziert und noch vor dem Eintritt in den aktiven Bereich lateral homogen verteilt werden können. Je größer der Abstand zum aktiven Bereich, desto besser ist bei vorgegebener Leitfähigkeit in lateraler Richtung in der Regel die Stromaufweitung.

Bei Nitrid-Verbindungshalbleitermaterialien weist n-leitendes Material, z.B. n-GaN, oftmals eine erheblich größere Leitfähigkeit in lateraler Richtung auf als p-leitendes Material, z.B. p-GaN. Der vergleichsweise kleinflächig kontaktierte Bereich 6 des Halbleiterkörpers 2 ist daher bevorzugt n-leitend und der mit der großflächigen Kontaktschicht kontaktierte Bereich 5 des Halbleiterkörpers p-leitend ausgebildet.

Eine Kontaktfläche des zweiten Kontakts 8 zum Halbleiterkörper 2 - also der Flächeninhalt der mechanischen Kontaktfläche zwischen dem Halbleiterkörper und diesem Kontakt - kann 50 % oder weniger, bevorzugt 40 % oder weniger, besonders bevorzugt 30 % oder weniger der Kontaktfläche des ersten Kontakts 7 zum Halbleiterkörper betragen.

Anstatt die Reflektorschicht wie dargestellt als Teil eines Kontakts auszuführen, kann auch eine dielektrische Reflektorschicht eingesetzt werden. In diesem Falle ist die dielektrische Reflektorschicht für den Durchtritt des ersten Kontakts zweckmäßigerweise durchbrochen (nicht dargestellt). Auf diese Weise kann eine leitende Verbindung zwischen der Anschlussfläche des ersten Kontakts und der Kontaktschicht hergestellt werden.

In einer bevorzugten Ausgestaltung ist im Halbleiterkörper 2 seitens der Hauptfläche 9 und insbesondere auf der Seite des aktiven Bereichs 4, auf der die Reflektorschicht 71 und/oder die Kontaktschicht 72 angeordnet ist, ein Braggspiegel monolithisch integriert. Der Braggspiegel umfasst bevorzugt eine alternierende Anordnung hoch- und niedrigbrechender Halbleiterschichten. Die Halbleiterschichten können durch Schichten im Bereich 5 des Halbleiterkörpers gebildet sein. Die in Richtung der Auskoppelfläche 19 gelenkte Strahlungsleistung kann so vereinfacht erhöht werden.

Zur Herstellung der Kontaktstruktur wird beispielsweise zunächst die Kontaktschicht 71 und gegebenenfalls die Reflektorschicht 72, vorzugsweise ganzflächig, auf Material für den Halbleiterkörper 2 abgeschieden. Nachfolgend können die Kontaktschicht und der Halbleiterkörper bereichsweise, z.B. mittels Ätzen unter Verwendung einer geeigneten strukturierten Maske, für die Ausnehmungen entfernt werden und die Isolationsschicht 10 vorgesehen werden. Diese Isolationsschicht wird vorzugsweise vollflächig abgeschieden und nachfolgend für die Kontaktstellen ausgespart, z.B. über Ätzen unter Verwendung einer geeigneten strukturierten Maske.

Daraufhin kann der zweite Kontakt 8 aufgebracht werden.

Kontaktfortsätze 84 können daraufhin mit der zweiten Isolationsschicht 13 bedeckt werden. Die Isolationsschicht 13 kann nachfolgend bereichsweise entfernt werden und die verbleibenden Teile der Kontakte 7, 8 können aufgebracht werden.

Die mehrlagige Struktur des ersten Kontakts 7 - eine Lage mit der Kontaktschicht und gegebenenfalls der Reflektorschicht einerseits und eine weitere Lage mit dem verbleibenden Teil des ersten Kontakts andererseits - erleichtert dabei in Kombination mit der elektrischen Isolation der beiden Kontakte voneinander das Ausbilden einer Kontaktstruktur für das optoelektronische Bauelement 1. Die Kontaktfortsätze können insbesondere nahezu beliebig geformt und verteilt über den Halbleiterkörper verlaufen.

Aufgrund der beidseitigen Isolierung des zweiten Kontakts - einerseits von der Hauptfläche 9 und andererseits vom zweiten Kontakt 8 mittels der Isolationsschichten 10 und 13 - wird das Ausbilden eines beliebigen Verlaufs von Kontaktfortsätzen über den Halbleiterkörper weitergehend vereinfacht. Weiterhin kann eine derartige Kontaktstruktur im Verbund, also gleichzeitig für eine Mehrzahl von Halbleiterkörpern, auf einfache Weise hergestellt werden. Die Verbundfertigung ist daher besonders kostengünstig.

Ein für die Verbundfertigung geeignetes Verfahren für die Herstellung einer Mehrzahl von optoelektronischen Bauelementen ist in der WO 2005/081319 beschrieben.

Auf die Auskoppelfläche 19 kann, vorzugsweise noch im Verbund, ein weiteres Element aufgebracht sein (nicht explizit dargestellt). Beispielsweise kann eine Lumineszenzkonversionsschicht mit einem Konversionsstoff auf die Auskoppelfläche aufgebracht sein. Diese Schicht kann im aktiven Bereich erzeugte Strahlung absorbieren und in Strahlung einer größeren Wellenlänge umwandeln. Die beiden Strahlungen können sich mischen, so dass auf der der Lumineszenzkonversionsschicht abgewandten Seite des Bauelements Strahlung mit einer Mischfarbe, z.B. weißes Licht, abgestrahlt wird. Geeignete Konversionsstoffe sind beispielsweise in der Druckschrift WO 98/12757 beschrieben. Alternativ oder ergänzend kann auf die Auskoppelfläche ein optisches Element, z.B. ein refraktives Element zur Strahlformung, insbesondere eine Linse, oder ein diffraktives Element, angeordnet und insbesondere auf das Bauelement aufgebracht sein. Weiterhin kann seitens der Auskoppelfläche eine photonische Kristallstruktur angeordnet sein.

Das Aufbringen derartiger Elemente auf die Auskoppelfläche 19 oder das Ausbilden einer Auskoppelstruktur in der Auskoppelfläche wird erleichtert, falls die Auskoppelfläche frei von Kontaktelementen ist.

Weiterhin sind die Anschlussflächen der Kontakte sehr nahe am aktiven Bereich angeordnet, so dass der thermische Widerstand, z.B. gegenüber einem Bauelement, bei dem der Träger 3 zwischen einer Anschlussfläche und dem aktiven Bereich angeordnet ist, für die Wärmeabfuhr vom aktiven Bereich vorteilhaft gering ist.

Gegenüber herkömmlichen Opto-Bauteilen, die einen Halbleiterchip zur Strahlungserzeugung umfassen, der in einem den Chip schützenden Gehäuse oder auf einem Leiterrahmen montiert ist, wobei die Chips dieser Bauteile nach der Montage für jedes Bauteil einzeln und nicht verbundmäßig verkapselt werden, können die hierin beschriebenen Bauelemente komplett im Verbund hergestellt werden. Auf eine nachträgliche Verkapselung der Bauelemente zum Schutz derselben nach dem Vereinzeln von Bauelementen aus dem Verbund kann verzichtet werden.

Eine schützende Verkapselung kann mit Vorteil bereits im Verbund vorgesehen werden. Das Bauelement 1 weist bevorzugt eine Verkapselung 40 auf, die in Figur 1 gestrichelt angedeutet ist. Der Halbleiterkörper 2 ist zweckmäßigerweise in die Verkapselung 40 eingebettet. Die Verkapselung 40 ist Teil des vereinzelten Bauelements. Die Verkapselung 40 kann eine oder eine Mehrzahl vereinzelter Aussenflächen 41 aufweisen. Die Verkapselung kann bereits im Verbund vorgesehen werden, aus dem die Bauelemente vereinzelt werden.

Die Verkapselung 40 schützt den aktiven Bereich 4 bevorzugt vor schädlichen äußeren Einflüssen, wie z.B. Feuchtigkeit. Für die Verkapselung kann eine Formmasse, z.B. BCB, auf den Halbleiterkörper aufgebracht und insbesondere an diesen angeformt sein. Die Formmasse wird zweckmäßigerweise nach dem Aufbringen gehärtet. Die gehärtete Verkapselung ist mechanisch stabil und schützt den aktiven Bereich. Die Verkapselung 40 kann den Halbleiterkörper 2 umgreifen. Der Halbleiterkörper wird durch die Verkapselung, vorzugsweise in Zusammenwirken mit dem Träger, geschützt. Die Verkapselung 40 erstreckt sich bevorzugt entlang aller nicht dem Träger 3 zugewandten Seiten des Halbleiterkörpers 2. Die Anschlussflächen 70, 80 liegen auf der dem Halbleiterkörper 2 abgewandten Seite der Verkapselung 40 vorzugsweise frei.

Die Verkapselung ist bevorzugt strahlungsdurchlässig für im aktiven Bereich zu erzeugende Strahlung.

Nitrid-Verbindungshalbleiter sind besonders widerstandsfähig gegen äußere Einflüsse, so dass auf eine Verkapselung bei einem Nitrid-basierten Bauelement vergleichsweise risikolos verzichtet werden kann.

Phosphid- und Arsenid-Verbindungshalbleiter sind demgegenüber, insbesondere falls sie Al enthalten, empfindlicher, z. B. im Hinblick auf Feuchtigkeit. Das Vorsehen einer Verkapselung ist bei Bauelementen, deren Halbleiterkörper eines dieser Materialien enthält, daher von besonderem Vorteil.

Weiterhin können die Bauelemente einen sehr geringen Platzbedarf aufweisen. Das Verhältnis des Flächeninhalts der vom Halbleiterkörper 2 überdeckten Fläche in Aufsicht auf die Hauptfläche 9 oder die Oberfläche 24 zu dem Inhalt der gesamten Fläche, über die sich das Bauelement in Aufsicht auf die Hauptfläche 9 oder die Oberfläche 24 erstreckt, kann größer als 0,2, bevorzugt größer als 0,3, besonders bevorzugt größer als 0,5, am meisten bevorzugt größer als 0,7 sein. Herkömmliche Miniatur-Bauformen weisen ein entsprechendes Verhältnis von kleiner als 0,1 auf.

Eine Oberfläche des Halbleiterkörpers, vorzugsweise die der Hauptfläche 9 abgewandte Oberfläche 24 des Halbleiterkörpers kann eine Oberflächenstruktur 21 mit Erhebungen und Vertiefungen aufweisen. Durch eine Oberflächenstruktur 21 kann der Strahlungsaustritt aus dem Halbleiterkörper 2 und insbesondere der Strahlungsübertritt von dem Halbleiterkörper 2 in den Träger 3 erleichtert werden.

Eine derartige Struktur kann beispielsweise durch Aufrauen dieser Oberfläche des Halbleiterkörpers, z.B. durch Ätzen, oder, insbesondere falls der Träger aus dem Aufwachssubstrat gebildet ist, durch den gezielten Einsatz eines unebenen Aufwachssubstrats erzielt werden. Über ein unebenes Aufwachssubstrat kann gezielt eine Versetzungsbildung in den epitaxierten substratseitigen Halbleiterschichten herbeigeführt werden, wobei aufgrund der Versetzungen eine unebene Oberfläche gebildet wird. Eine derartige Oberflächenstruktur 21 ist in der stark vereinfachten Schnittansicht in Figur 1D schematisch dargestellt.

Durch eine derartige Oberflächenstruktur 21 kann eine Reflexion, z. B. Totalreflexion, an der Oberfläche 24 gestört werden. Der Austritt von Strahlung aus dem Halbleiterkörper 2 wird so erleichtert. Wird beispielsweise bei einem Nitrid-Verbindungshalbleiter-Halbleiterkörper ein Saphir-Träger, der vorzugsweise aus dem Aufwachssubstrat gefertigt ist, eingesetzt, so weist dieser einen geringeren Brechungsindex als das Nitrid-Verbindungshalbleitermaterial auf, sodass die Gefahr fortgesetzter Totalreflexion im Halbleiterkörper besteht. Diese Totalreflexion kann durch die Oberflächenstruktur 21 gestört werden.

Der Halbleiterkörper 2 kann im Bereich des Durchbruchs durch den aktiven Bereich 4 angeschrägt ausgebildet sein. Bevorzugt ist (sind) Ausnehmung(en) 11 des Halbleiterkörpers 2, in der (denen) sich der zweite Kontakt 8 erstreckt, angeschrägt ausgebildet. Eine derart angeschrägte Ausbildung ist in der Teilschnittansicht in Figur 1E schematisch skizziert. Figur 1E zeigt eine Teilansicht, zum Beispiel gemäß Figur 1C.

Über Reflexion von Strahlung an dem im Durchbruch angeordneten Kontaktmaterial des zweiten Kontakts 8, das eine schräge, dem aktiven Bereich zugewandte Fläche aufweist, kann der Strahlengang im Halbleiterkörper gestört werden. Die aus dem Halbleiterkörper auskoppelbare Strahlungsleistung kann hierüber erhöht werden.

Vorzugsweise verjüngt sich die Ausnehmung ausgehend von der Hauptfläche 9 des Bauelements 1 in Richtung der der Hauptfläche 9 abgewandten Seite des aktiven Bereichs 4. Eine derartige Formgebung kann beispielsweise durch Ausbilden der Ausnehmung über Trockenätzen mit einer entsprechend angeschrägten Maske erzielt werden.

Eine Wand 110 der Ausnehmung 11 beziehungsweise des Durchbruchs kann schräg zum aktiven Bereich 4 und/oder schräg zur Hauptfläche 9 verlaufen. Ein Winkel γ für die Schräge von zwischen einschließlich 35° und einschließlich 55°, zum Beispiel 45°, hat sich zum Beispiel für eine Störung des Strahlengangs im Halbleiterkörper besonders vorteilhaft erwiesen. Die Wand 110 und der aktive Bereich 4 bzw. eine Verlängerung der Wand und die Hauptfläche 9 können den Winkel γ einschließen. Im Bereich des Durchbruchs und insbesondere der Ausnehmung 11 kann eine dielektrische Spiegelschicht vorgesehen sein.

Die dielektrische Spiegelschicht kann mittels der Isolationsschicht 10 gebildet sein.

Die dielektrische Spiegelschicht kann im Bereich des Durchbruchs bzw. der Ausnehmung zwischen dem zweiten Kontakt und dem Halbleiterkörper angeordnet sein.

Das im Bereich des Durchbruchs angeordnete Material des zweiten Kontakts 8 ist zweckmäßigerweise derart gewählt, dass der zweite Kontakt im Bereich des Durchbruchs eine hohe Reflektivität aufweist. Der zweite Kontakt kann also in diesem Bereich eine elektrisch leitfähige Spiegelschicht 90 aufweisen. Bevorzugt ist der zweite Kontakt im Bereich des Durchbruchs - also insbesondere in dem Bereich, welcher von der Kontaktstelle 12 abgewandt ist und durch die Reflektorschicht 72 beziehungsweise die Kontaktschicht 71 hindurchragt - reflektierend ausgebildet sein, zum Beispiel mit einem Material hoher Reflektivität. Es eignet sich beispielsweise ein Metall, insbesondere Ag oder Al, oder eine Legierung, die zweckmäßigerweise eine Mehrzahl von Metallen aufweist, für die elektrisch leitfähige Spiegelschicht 90.

Der zweite Kontakt 8 weist bevorzugt eine Kontaktschicht 87 auf. Die Kontaktschicht 87 ist zweckmäßigerweise für die elektrische Kontaktbildung zum Halbleitermaterial mittels des zweiten Kontakts optimiert ausgeführt. Beispielsweise enthält die Kontaktschicht 87 ein Metall oder ein Metalllegierung, wie etwa Pt. Die Kontaktschicht 87 kann eine Dicke von 50 nm oder weniger, bevorzugt von 30 nm oder weniger, besonders bevorzugt von 20 nm oder weniger, beispielsweise von 10 nm oder weniger aufweisen.

Die Kontaktschicht 87 kann, insbesondere in der Kontaktstelle 12 des zweiten Kontakts 8 zum Halbleitermaterial, an das Halbleitermaterial angrenzen. Beispielsweise kann die Kontaktschicht 87 in einer Aussparung der Isolationsschicht 10 angeordnet sein. Auf der vom Halbleitermaterial abgewandten Seite der Kontaktschicht 97 kann die elektrisch leitfähige Spiegelschicht 90 des zweiten Kontakts 8 angeordnet sein.

Eine Kontaktschicht 87 des zweiten Kontakts 8 kann selbstverständlich auch bei den weiter oben und im Folgenden beschriebenen Bauelementen vorgesehen sein. Gleiches gilt für die elektrisch leitfähige Spiegelschicht 90.

Obwohl die Darstellung in Figur 1E nur einen Durchbruch bzw. eine Ausnehmung 11 mit schräg verlaufenden Wänden zeigt, können selbstverständlich auch die anderen Durchbrüche gemäß Figur 1 und der im weiteren beschriebenen Ausführungsbeispiele gemäß der Beschreibung im Zusammenhang mit Figur 1E ausgeführt sein.

Das Bauelement 1 kann insbesondere derart ausgeführt sein, dass auf der Auskoppelfläche 19 im Betrieb des Bauelements und/oder im ausgeschalteten Zustand des Bauelements keine Unregelmäßigkeiten in der Helligkeit erkennbar sind. Im Betrieb des Bauelements können zum Beispiel Bereiche geringer Strahlungsleistung, welche aufgrund des durchbrochenen aktiven Bereichs in diesen Bereichen auftreten könnten, vermieden werden. Die Auskoppelfläche 19 kann demnach im Betrieb und/oder im ausgeschalteten Zustand ein gleichförmiges Erscheinungsbild aufweisen. Dazu können zum Beispiel die Reflektorschicht 72 und/oder die angeschrägten Wände der Ausnehmung 11 bzw. des Durchbruchs beitragen.

Bevorzugt weist die Auskoppelfläche 19 des Bauelements Erhebungen und Vertiefungen auf. Mittels einer derartigen Auskoppelstruktur kann die über die Auskoppelfläche austretende Strahlungsleistung aufgrund gestörter (Total)Reflexion an der Auskoppelfläche erhöht werden. Eine solche Auskoppelstruktur ist in den Figuren 1B und 1C gestrichelt angedeutet. Die Auskoppelstruktur kann mittels Ätzen oder einer mechanischen Behandlung, zum Beispiel Schleifen, ausgebildet werden.

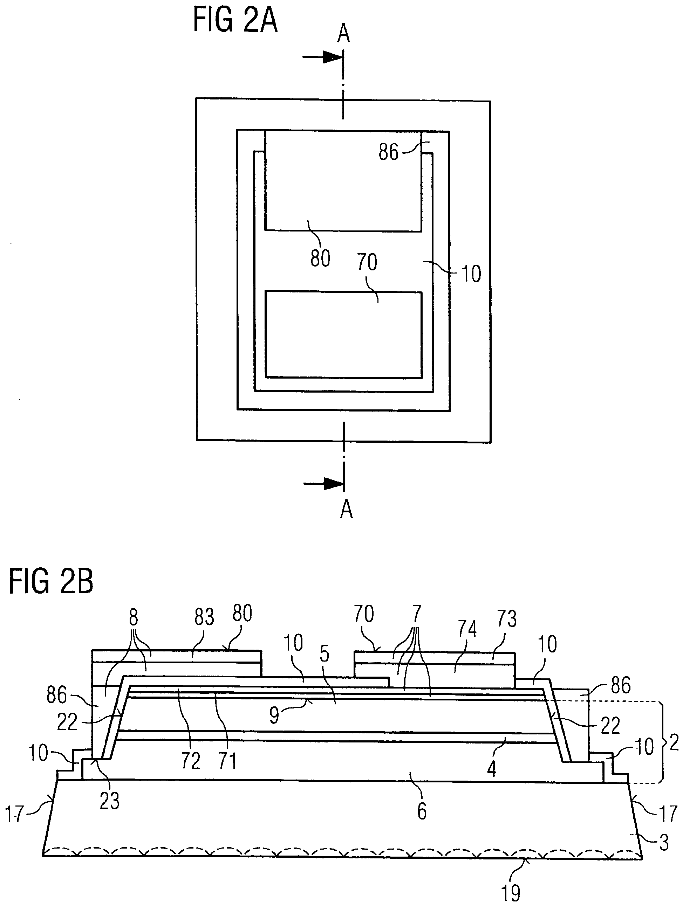

Figur 2 zeigt ein weiteres Ausführungsbeispiel eines optoelektronischen Bauelements anhand einer schematischen Aufsicht in Figur 2A und einer schematischen Schnittansicht in Figur 2B. Der Schnitt in Figur 2B ist dabei entlang der Linie A-A in Figur 2A genommen. Im Wesentlichen entspricht das Ausführungsbeispiel gemäß Figur 2 dem im Zusammenhang mit Figur 1 beschriebenen Ausführungsbeispiel.

Im Unterschied dazu wird der zweite Kontakt 8 für die elektrische Kontaktierung des Halbleiterkörpers auf der von der Hauptfläche 9 abgewandten Seite des aktiven Bereichs 4, insbesondere die Kontaktierung des Bereichs 6 des Halbleiterkörpers 2, neben einer den Halbleiterkörper 2 lateral begrenzenden Seitenfläche 22 geführt.

Auf Ausnehmungen und Kontaktfortsätze gemäß dem Ausführungsbeispiel in Figur 1 und dementsprechend auch auf eine zweite Isolationsschicht 13 kann so verzichtet werden. Die Kontaktschicht 71 und vorzugsweise die Reflektorschicht 72 kann als durchgehende Schicht ausgeführt sein. Auf Aussparungen in diesen Schichten zur Durchführung des zweiten Kontakts zu dem Bereich des Halbleiterkörpers, der auf der von der Kontaktschicht 71, der Reflektorschicht 72, der Anschlussfläche 70 und/oder der Anschlussfläche 80, abgewandten Seite des aktiven Bereichs 4 angeordnet ist, kann verzichtet werden. Auch auf einen Durchbruch des aktiven Bereichs kann verzichtet werden. Die für die Strahlungserzeugung zur Verfügung stehende Fläche des aktiven Bereichs ist so vergrößert.

Der zweite Kontakt erstreckt sich von der dem aktiven Bereich 4 abgewandten Seite der Kontaktschicht 71 ausgehend lateral neben dem Halbleiterkörper auf die der Kontaktschicht abgewandte Seite des aktiven Bereichs und ist auf dieser Seite elektrisch leitend mit dem Halbleiterkörper verbunden.

Eine Kontaktregion 86 des zweiten Kontakts 8 erstreckt sich hierzu neben einer den aktiven Bereich 4 begrenzenden Seitenfläche 22 des Halbleiterkörpers 2 bis zu der der Hauptfläche 9 abgewandten Seite des aktiven Bereichs 4. Die Kontaktregion ist vom aktiven Bereich elektrisch isoliert. Die Kontaktregion 86 ist vorzugsweise auf der Isolationsschicht 10 abgeschieden. Die Kontaktregion 86 ist in einem Kontaktbereich 23 auf der von der Hauptfläche 9 abgewandten Seite des aktiven Bereichs 4 elektrisch leitend mit dem Halbleiterkörper, insbesondere dem Bereich 6, verbunden. Vorzugsweise umläuft die Kontaktregion 86 den Halbleiterkörper rahmenartig. Eine homogene Ladungsträgerinjektion in den aktiven Bereich 4 zur großflächigen Strahlungserzeugung kann so erleichtert werden. Der Flächeninhalt des Kontaktbereichs 23 ist bevorzugt kleiner als der Flächeninhalt der mit der Kontaktschicht kontaktierten Fläche des Halbleiterkörpers (vergleiche obige Ausführungen im Zusammenhang mit Figur 1).

Weiterhin sind Seitenflächen 22 des Halbleiterkörpers 2 angeschrägt ausgeführt. Durch Reflexion an der Seitenfläche oder an der dem Halbleiterkörper zugewandten und schräg verlaufenden Oberfläche der Kontaktregion 86 des zweiten Kontakts 8 kann der Strahlengang im Halbleiterkörper gestört und dementsprechend die Gefahr einer fortgesetzten Totalreflexion im Halbleiterkörper vermindert werden. Hierdurch kann die aus dem Halbleiterkörper tretende Strahlungsleistung erhöht werden.

Vorzugsweise sind Seitenflächen 17 des Trägers 3 angeschrägt ausgebildet. Eine Totalreflexion im Träger kann so gestört werden.

Entsprechend der Darstellung in Figur 2 angeschrägte Seitenflächen des Halbleiterkörpers 2 und/oder des Trägers 3 können selbstverständlich auch beim Bauelement gemäß Figur 1 oder den im Folgenden beschriebenen Bauelementen vorgesehen sein.

Das Bauelement 1 gemäß Figur 2 kann auch mit einer Verkapselung 40 versehen sein, wie sie in den Figuren 1B und 1C angedeutet ist. Weiterhin kann die dem Träger 3 zugewandte Seite des Halbleiterkörpers 2 eine Struktur gemäß Figur 1D aufweisen.

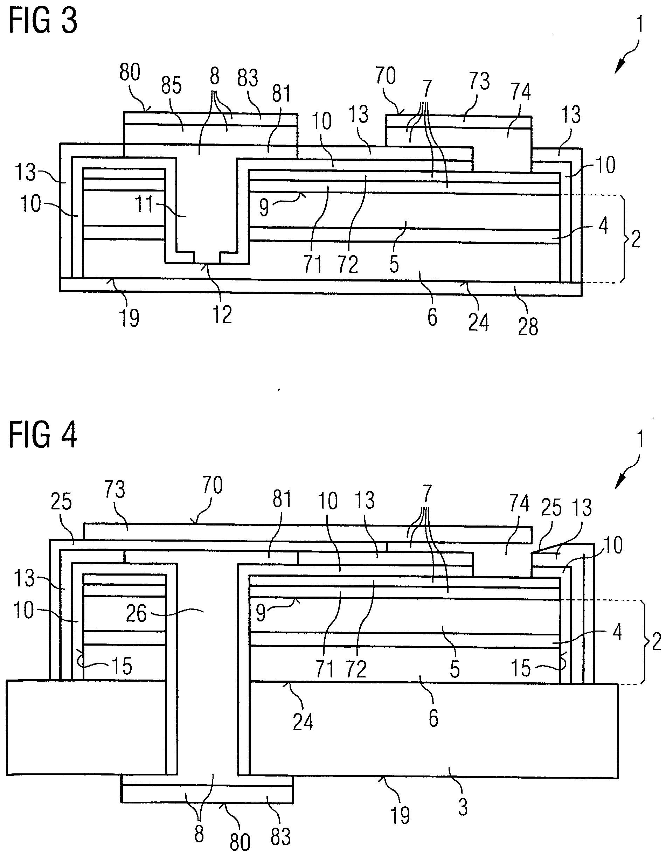

Figur 3 zeigt ein weiteres Ausführungsbeispiel eines optoelektronischen Bauelements 1 anhand einer schematischen Schnittansicht. Im Wesentlichen entspricht das Bauelement 1 dem im Zusammenhang mit Figur 1 beschriebenen Bauelement. Im Unterschied hierzu ist auf einen Träger, der den Halbleiterkörper 2 mechanisch stabilisiert, verzichtet.

Mittels der von der Hauptfläche 9 abgewandten Oberfläche 24 des Halbleiterkörpers 2 kann die Auskoppelfläche 19 gebildet sein. Diese Oberfläche 24 kann eine Oberflächenstruktur aufweisen (vgl. die Oberflächenstruktur 21 in Figur 1D, in Figur 3 nicht explizit dargestellt).

Die Oberfläche 24 kann mit einer Schutzschicht 28 versehen sein. Für die Schutzschicht 28 sind z.B. die weiter oben für die Isolationsschicht oder die Verkapselung genannten Materialien geeignet.

Das Bauelement 1, beispielsweise eine Lumineszenzdiode, ist also frei von einem gesondert vorgesehenen, den Halbleiterkörper, der bevorzugt epitaktisch gewachsen ist, stabilisierenden Element. Auf den Träger 3, insbesondere das Aufwachssubstrat, kann verzichtet werden.

Das trägerlose Bauelement kann aus dem Halbleiterkörper, den Kontakten und auf den Halbleiterkörper aufgebrachten, insbesondere auf den Halbleiterkörper abgeschiedenen, Schichten, die mit Vorzug jeweils nicht selbsttragend ausgebildet sind, bestehen. Die Schichten können jeweils mittels eines PVD- oder CVD-Verfahrens abgeschieden sein.

Das trägerlose Bauelement zeichnet sich durch eine besonders geringe Bauhöhe aus.

Ein Träger 3, z.B. das Aufwachssubstrat des Halbleiterkörpers, kann als temporärer Zwischenträger während der Herstellung eines derart trägerlosen Bauelements 1 vorgesehen sein. Der Träger 3 wird jedoch während des Herstellungsverfahrens entfernt. Vorzugsweise wird der Träger 3 vollständig entfernt.

Auch die weiteren der oben und im Folgenden beschriebenen Bauelemente können als trägerlose Bauelemente ausgeführt sein.

Figur 4 zeigt ein weiteres Ausführungsbeispiel eines optoelektronischen Bauelements anhand einer schematischen Schnittansicht.

Das in Figur 4 gezeigte optoelektronische Bauelement 1 entspricht im Wesentlichen dem im Zusammenhang mit Figur 1 beschriebenen Bauelement. Die Schnittansicht in Figur 4 entspricht dabei der in Figur 1C gezeigten Schnittansicht, wobei ein anderer, entsprechend der Linie A-A in Figur 1A genommener Schnitt durch das Bauelement gemäß der in Figur 1B gezeigten Ansicht ausgebildet sein kann. Insbesondere kann der Stromaufweitungsbereich 81 einen oder eine Mehrzahl von Kontaktfortsätzen 84 aufweisen.

Im Unterschied zu dem im Zusammenhang mit Figur 1 beschriebenen Bauelement sind die Anschlussflächen 70, 80 der beiden Kontakte auf verschiedenen Seiten des aktiven Bereichs 4 angeordnet. Die Anschlussfläche 70 des ersten Kontakts 7 ist dabei auf der vom aktiven Bereich 4 abgewandten Seite der Hauptfläche 9 angeordnet. Die Anschlussfläche 80 des zweiten Kontakts 8 ist auf der vom aktiven Bereich abgewandten Seite der Oberfläche 24, insbesondere der vom Halbleiterkörper 2 abgewandten Seite des Trägers 3, angeordnet.

Der Stromaufweitungsbereich 81 und die Anschlussfläche 80 des zweiten Kontakts 8 sind auf verschiedenen Seiten des aktiven Bereichs 4 und insbesondere auf verschiedenen Seiten des Halbleiterkörpers 2 angeordnet.

Die Anschlussfläche 70 des ersten Kontakts erstreckt sich zweckmäßigerweise großflächig über die Hauptfläche 9 des Halbleiterkörpers 2.

Eine Stromaufweitung im Stromaufweitungsbereich 81 des zweiten Kontakts 8 und ein externer elektrischer Anschluss dieses Kontakts über die Anschlussfläche 80 können demnach auf verschiedenen Seiten des aktiven Bereichs und insbesondere des Halbleiterkörpers erfolgen.

Zwischen dem zweiten Kontakt 8 und der Anschlussfläche 70 des ersten Kontakts verläuft zweckmäßigerweise durchgehend Isolationsmaterial. Zusätzlich zu den Isolationsschichten 10 beziehungsweise 13 kann hierzu eine weitere Isolationsschicht 25 vorgesehen sein. Die Isolationsschicht 25 kann jedoch gegebenenfalls auch mittels der Schicht 13 gebildet sein (nicht dargestellt). Die Isolationsschichten 13 und 26 sind dann einstückig ausgeführt.

Im Unterschied zum Ausführungsbeispiel gemäß Figur 1 weist der Halbleiterkörper 2 eine den Halbleiterkörper vollständig durchdringende Aussparung 26 auf. Die Aussparung erstreckt sich also durch den gesamten Halbleiterkörper und setzt sich vorzugsweise auch durch den gesamten Träger 3 fort. Die Aussparung 26 kann zusätzlich zu Ausnehmungen 11 gemäß Figur 1B vorgesehen sein. Die Ausnehmungen durchdringen den Halbleiterkörper im Gegensatz zur Aussparung bevorzugt nur teilweise.

Der zweite Kontakt 8 erstreckt sich von der Hauptfläche 9 des Halbleiterkörpers ausgehend durch den gesamten Halbleiterkörper 2 und ist im Bereich der Aussparung 26 vom aktiven Bereich 4 und insbesondere dem Halbleiterkörper sowie vorzugsweise dem Träger 3 elektrisch isoliert. Hierzu kann die Aussparung 26 mit Isolationsmaterial, etwa der Isolationsschicht 10, ausgekleidet sein. Die Aussparung 26 ist lateral vorzugsweise umlaufend vom Halbleiterkörper 2 bzw. dem Träger 3 begrenzt. Über den sich durch die Aussparung 26 erstreckenden Teil des Kontakts 8 kann die Anschlussfläche 80, insbesondere die Anschlussschicht 83, mit dem Stromaufweitungsbereich 81 elektrisch leitend verbunden sein.

Die seitens der Hauptfläche 9 vorgesehene Anschlussfläche 70 ist vorzugsweise zur elektrisch leitenden Verbindung zu einem Anschlussleiter eines Anschlussträgers mittels einer elektrisch leitenden Verbindungsschicht vorgesehen. Durch die gegenüber dem Ausführungsbeispiel gemäß Figur 1 großflächigere Ausführung der Anschlussfläche 70 kann gegebenenfalls eine flächigere und damit lagestabilere Verbindung zu dem Anschlussträger erreicht werden.

Die Anschlussfläche 80 ist vorzugsweise zu einer Verbindung mit einem Bonddraht vorgesehen. Eine Stromaufweitung kann im Bereich 81 auf der vom aktiven Bereich abgewandten Seite der Reflektorschicht erreicht werden.

Für den externen elektrischen Anschluss des zweiten Kontakts über die Anschlussfläche 80 wird gegenüber einer Stromaufweitung über die Haupterstreckungsrichtung des Halbleiterkörpers eine vergleichsweise geringe Fläche benötigt. Die Anschlussfläche 80 erstreckt sich demnach bevorzugt über eine kleinere Fläche des Halbleiterkörpers 2 als der Stromaufweitungsbereich 81.

Der Flächeninhalt der Anschlussfläche 80 ist vorzugsweise kleiner als der Flächeninhalt der der Hauptfläche 9 zugewandten Seite der Kontaktschicht 71 beziehungsweise der Reflektorschicht 72. Seitens der Auskoppelfläche 19 des Bauelements kann zwar so ein absorbierendes Element wie die Anschlussschicht 83 vorgesehen sein, der in dieser Schicht absorbierte Strahlungsanteil kann jedoch aufgrund der vorzugsweise kleinflächigen Ausführung der Anschlussfläche entsprechend gering gehalten werden.

Das Vorsehen von Anschlussflächen 70, 80 verschiedener Kontakte auf zwei verschiedenen Seiten des aktiven Bereichs hat weiterhin den Vorteil, dass ein Kontakt mittels einer Verbindungsschicht und der andere Kontakt mittels einer Drahtverbindung angeschlossen werden kann. Bei der elektrischen Verschaltung einer Mehrzahl von Bauelementen kann dies von Vorteil sein.

Für die Durchführung des Kontakts 8 zur Anschlussfläche 80 kann anstelle einer der Ausnehmungen 11 gemäß Figur 1 die Aussparung 26 vorgesehen sein. Die weiteren Ausnehmungen können entsprechend Figur 1B ausgebildet und angeordnet sein.

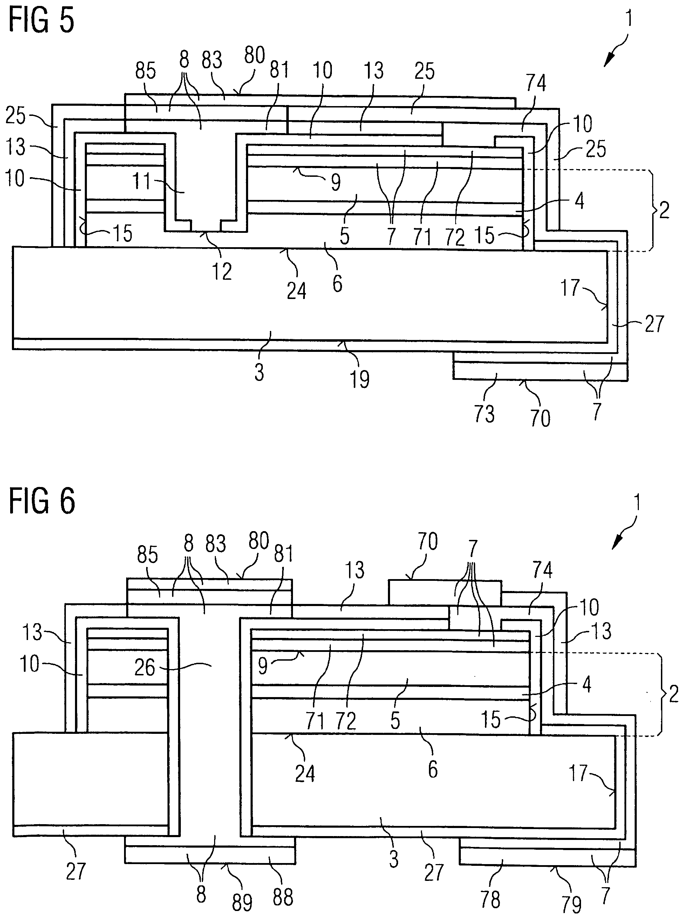

Figur 5 zeigt ein weiteres Ausführungsbeispiel eines optoelektronischen Bauelements 1 anhand einer schematischen Schnittansicht.

Im Wesentlichen entspricht das in Figur 5 gezeigte Bauelement dem im Zusammenhang mit Figur 4 beschriebenen Bauelement. Beiden Bauelementen ist gemein, dass die Anschlussflächen 70, 80 der beiden Kontakten 7, 8 auf verschiedenen Seiten des aktiven Bereichs 4 angeordnet sind. Im Unterschied zu Figur 4 erstreckt sich ein Kontakt, insbesondere der Kontakt 7, von der Hauptfläche 9 ausgehend neben und entlang der Seitenfläche 15 des Halbleiterkörpers 2 und bis über die der Hauptfläche 9 vom aktiven Bereich 4 aus gesehen gegenüberliegende Oberfläche 24 des Halbleiterkörpers 2. Die Schicht 74 des ersten Kontakts 7 kann hierzu entlang des Halbleiterkörpers 2 und insbesondere entlang einer Seitenfläche 17 des Trägers geführt sein.

Der Kontakt 7 ist im Bereich der Seitenfläche 15 vom aktiven Bereich 4 und insbesondere dem Halbleiterkörper 2 zweckmäßigerweise elektrisch isoliert. Die Schicht 74 kann bereichsweise in Isolationsmaterial, beispielsweise die Schichten 10 und 26 (beziehungsweise 13 bei einstückiger Ausbildung der Schichten 13 und 26), eingebettet sein.

Im Gegensatz zu Figur 4 wurde bei dem Bauelement 1 gemäß Figur 5 auf eine Aussparung des Halbleiterkörpers 2 und insbesondere des Trägers 3 verzichtet. Weiterhin ist im Unterschied zu Figur 5 die Anschlussfläche 80 des zweiten Kontakts auf der vom aktiven Bereich 4 abgewandten Seite der Hauptfläche 9 angeordnet und erstreckt sich vorzugsweise großflächig über diese Hauptfläche 2. Die Anschlussfläche 70 des ersten Kontakts dagegen ist auf der vom aktiven Bereich 4 abgewandten Seite der Oberfläche 24 und insbesondere der vom aktiven Bereich abgewandten Seite des Trägers 3 angeordnet.

Zwischen der Anschlussfläche 70 und dem aktiven Bereich 4 ist zweckmäßigerweise elektrisches Isoliermaterial angeordnet, um einen Kurzschluss der Kontakte 7 und 8 zu vermeiden. Hierzu kann eine weitere Isolationsschicht 27 vorgesehen sein, die sich über die Oberfläche 24 erstreckt und zwischen der Anschlussfläche 70 und dem aktiven Bereich 4 angeordnet ist. Das Isolationsmaterial erstreckt sich vorzugsweise durchgehend zwischen der Oberfläche 24, insbesondere dem Träger 3, und dem ersten Kontakt 7. Für die Isolationsschichten 25 und 27 sind ebenfalls die für die Schichten 10 und 13 angeführten Materialien geeignet.

Ist der Träger 3 elektrisch isolierend ausgebildet, wie zum Beispiel ein Saphirträger, so kann auf die Isolationsschicht 27 verzichtet werden.

Figur 6 zeigt ein weiteres Ausführungsbeispiel eines optoelektronischen Bauelements anhand einer schematischen Schnittansicht.

Im Wesentlichen entspricht das in Figur 6 dargestellte Bauelement 1 dem im Zusammenhang mit Figur 1 beschriebenen Bauelement. Insbesondere sind die Anschlussflächen 70 und 80 der beiden Kontakte 7, 8 auf der gleichen Seite des aktiven Bereichs angeordnet.

Im Unterschied zu dem Bauelement gemäß Figur 1 weist ein Kontakt, vorzugsweise weisen beide Kontakte, zwei, auf verschiedenen Seiten des aktiven Bereichs angeordnete Anschlussflächen auf. Der zweite Kontakt 8 weist zwei auf verschiedenen Seiten des aktiven Bereichs angeordnete Anschlussflächen 80 und 89 auf. Der erste Kontakt 7 weist zwei auf verschiedenen Seiten des aktiven Bereichs 4 angeordnete Anschlussflächen 70 und 79 auf.

Die Führung der Kontakte 7, 8 von der Hauptfläche 9 ausgehend zu und über die Oberfläche 24 kann dabei mittels einer Aussparung 26 wie im Zusammenhang mit Figur 4 beschrieben oder entlang einer den Halbleiterkörper lateral begrenzenden Seitenfläche 15 und insbesondere einer den Träger 3 lateral begrenzenden Seitenfläche wie im Zusammenhang mit Figur 5 beschrieben erfolgen. Der zweite Kontakt 8 ist dabei durch die Aussparung 26 und der erste Kontakt 7 entlang der Seitenfläche 15 geführt.

Ein derartiges Vorsehen von zwei Anschlussflächen für einen Kontakt auf verschiedenen Seiten des Halbleiterkörpers kann die Kontaktierungsfreiheitsgrade für einen externen elektrischen Anschluss des Bauelements 1 erhöhen. So kann das Bauelement jeweils mittels zweier auf der gleichen Seite des aktiven Bereichs angeordneter Anschlussflächen 80, 70 beziehungsweise 89, 79 entweder mittels Verbindungsschichten oder mittels Bonddrähten kontaktiert werden. Alternativ kann eine Anschlussfläche 79 oder 89 auf der einen Seite des aktiven Bereichs mittels einer Verbindungsschicht oder eines Bonddrahts angeschlossen werden und die andere Anschlussfläche 80 bzw. 70 mittels eines Bonddrahts bzw. einer Verbindungsschicht kontaktiert werden.
Die Kontaktierung mittels einer elektrisch leitenden Verbindungsschicht erfolgt vorzugsweise auf der für die Montage des Bauelements auf einem Anschlussträger vorgesehenen Seite.

Die Anschlussflächen 79, 89 können mittels einer zusätzlichen Anschlussschicht 88 beziehungsweise 78 gebildet sein.

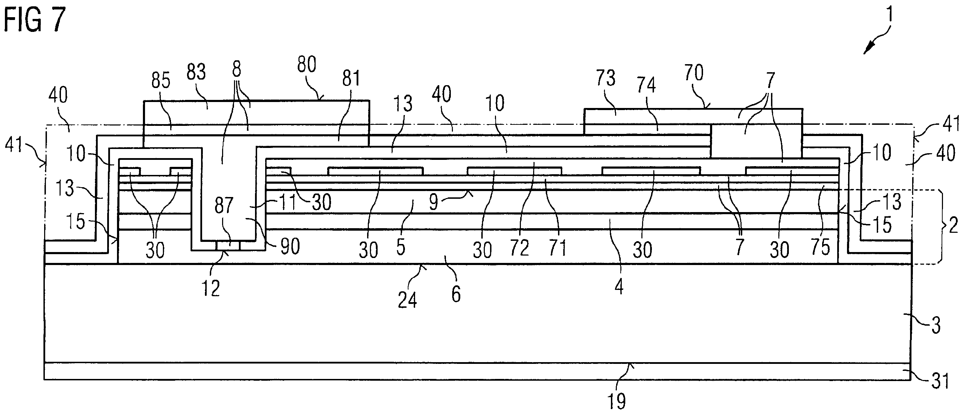

Figur 7 zeigt ein weiteres Ausführungsbeispiel eines optoelektronischen Bauelements anhand einer schematischen Schnittansicht.

Im Wesentlichen entspricht das Bauelement 1 dem im Zusammenhang mit Figur 1 beschriebenen Bauelement (vergleiche zum Beispiel die entsprechende Schnittansicht in Figur 1C). Im Unterschied hierzu weist das optoelektronische Bauelement 1 eine Haftschicht 75 auf. Die Haftschicht 75 ist bevorzugt derart ausgebildet, dass die Haftung vom Material für den ersten Kontakt 7 am Halbleiterkörper erhöht wird. Die Haftschicht kann elektrisch leitfähig ausgeführt sein und insbesondere Teil des ersten Kontakts 7 sein. Die Haftschicht kann ein Metall oder eine Legierung enthalten oder daraus bestehen. Die Haftschicht kann beispielsweise Ti enthalten oder daraus bestehen. Die Haftschicht 75 grenzt einerseits vorzugsweise an den Halbleiterkörper 2 und andererseits vorzugsweise an die Kontaktschicht 71 an. Für eine Verbesserung der Haftung einer Pt-Kontaktschicht 71 am Halbleitermaterial ist eine Ti-Haftschicht 75 besonders geeignet. Die Haftschicht weist zweckmäßigerweise eine Dicke von 10 nm oder weniger, bevorzugt von 5 nm oder weniger, besonders bevorzugt von 3 nm oder weniger, wie etwa von 2 nm oder weniger auf. Die Haftschicht kann insbesondere semitransparent ausgebildet sein. Weiterhin kann die Haftschicht gegebenenfalls als nicht durchgehende, zum Beispiel inselartig ausgebildete, Schicht ausgebildet sein.

Die Gefahr einer Delamination von Kontaktmaterial vom Halbleiterkörper wird durch das Vorsehen der Haftschicht verringert. Die Haftschicht 75 ist vorzugsweise vollflächig zwischen der Kontaktschicht 71 und dem Halbleiterkörper 2 angeordnet.

Weiterhin weist das Bauelement 1 eine dielektrische Spiegelschicht 30 auf. Die dielektrische Spiegelschicht 30 ist zwischen der Reflektorschicht 72 und dem Halbleiterkörper 2 angeordnet. Die dielektrische Spiegelschicht 30 kann zwischen der Reflektorschicht 72 und der Kontaktschicht 71 angeordnet sein. Für die elektrische Kontaktbildung zwischen Kontaktschicht und Reflektorschicht kann die dielektrische Spiegelschicht 30 einfach oder mehrfach ausgespart (durchbrochen) sein. Hierzu können entsprechende Vias, die mit Vorzug lateral und insbesondere umfangsseitig von der dielektrischen Spiegelschicht 30 begrenzt sind und sich durch die Spiegelschicht erstrecken können, vorgesehen sein. Der erste Kontakt 7 und/oder der zweite Kontakt 8 kann sich von der vom aktiven Bereich abgewandten Seite der dielektrischen Spiegelschicht 30 auf die dem aktiven Bereich zugewandte Seite der dielektrischen Speiegelschicht erstrecken. Die Haftschicht 75 kann zwischen der Spiegelschicht 30 und dem Halbleiterkörper 2 angeordnet sein.

Alternativ kann die Haftschicht 75 und/oder die Kontaktschicht 71 in entsprechenden Aussparungen der dielektrischen Spiegelschicht angeordnet sein (nicht explizit dargestellt). Die dielektrische Spiegelschicht kann gegebenenfalls zwischen der Kontaktschicht und der Haftschicht angeordnet sein (nicht explizit dargestellt).

Aufgrund der dielektrischen Spiegelschicht kann die Rückreflexion von Strahlung in den Halbleiterkörper mittels der Reflektorschicht 72 und der Spiegelschicht 30, welche einen Gesamtspiegel bilden, der ein elektrisch leitfähiges Material und ein Dielektrikum enthalten kann, verbessert werden.

Die dielektrische Spiegelschicht weist bevorzugt eine Dicke von mehr als λ/(4n) auf, wobei λ die Wellenlänge der im aktiven Bereich erzeugten Strahlung im Vakuum und n der Brechungsindex des Materials der dielektrischen Spiegelschicht ist. Eine Dicke der Spiegelschicht kann 50 nm oder mehr, bevorzugt 70 nm oder mehr, besonders bevorzugt 100 nm oder mehr, zum Beispiel 150 nm oder mehr betragen.
Die Dicke der dielektrischen Spiegelschicht ist bevorzugt kleiner oder gleich 500 nm, besonders bevorzugt kleiner oder gleich 400 nm. Ist die im Bereich des Durchbruchs bzw. der Ausnehmung 11 angeordnete Isolationsschicht, z.B. die Isolationsschicht 10, als (weitere) dielektrische Spiegelschicht ausgebildet (vgl. die Beschreibung zu Figur 1E), so kann sie eine entsprechende Dicke aufweisen.

Bei einer derart dicken Ausführung der Spiegelschicht wird das Ausbilden einer Vorzugsrichtung bei der
Strahlungsreflexion an der dielektrischen Spiegelschicht vermieden oder verringert. Die Reflektivität des kombinierten Spiegels mit der Spiegelschicht und der Reflektorschicht ist mit besonderem Vorteil im wesentlichen unabhängig vom Auftreffwinkel der Strahlung. Die Spiegelschicht enthält bevorzugt ein Siliziumnitrid, ein Siliziumoxid oder ein Siliziumoxinitrid oder besteht hieraus. Aufgrund der geringeren Absorption im blauen Spektralbereich eignet sich ein Siliziumoxid für Strahlung im ultravioletten oder blauen Spektralbereich besonders.

Ein Brechungsindex der dielektrischen Spiegelschicht ist bevorzugt kleiner als der des Halbleitermaterials, das den Halbleiterkörper seitens der dielektrischen Spiegelschicht begrenzt. Aufgrund des Brechungsindexsprungs kann Strahlung vermehrt in den Halbleiterkörper zurück reflektiert werden. So beträgt zum Beispiel der Brechungsindex von GaN ungefähr 2,3 und der von SiO₂ ungefähr 1,5.

Ein so genanntes low-k-Material, also ein Material mit niedrigem Brechungsindex, vorzugsweise einem Brechungsindex der kleiner als der von SiO₂ ist, eignet sich auch für die dielektrische Spiegelschicht.

Weiterhin weist das optoelektronische Bauelement 1 gemäß Figur 7 ein optisches Element 31 auf. Das optische Element ist vorzugsweise auskoppelseitig vorgesehen und kann insbesondere auf die Auskoppelfläche 19 aufgebracht sein. Das optische Element 31 kann als Lumineszenzkonversionselement ausgeführt sein. Das Lumineszenzkonversionselement kann, zum Beispiel durch einen geeigneten Lumineszenzkonversionsstoff, im aktiven Bereich 4 erzeugte Strahlung absorbieren und als Strahlung einer anderen Wellenlänge, zum Beispiel einer größeren Wellenlänge, re-emittieren. Das optoelektronische Bauelement kann demnach mischfarbiges Licht, insbesondere weißes Licht, erzeugen. Die Mischfarbe entsteht dabei aus Mischung der im aktiven Bereich erzeugten Strahlung und der vom Lumineszenzkonversionselement reemittierten Strahlung. Alternativ oder ergänzend kann das optische Element ein optisches Element zur Strahlformung, etwa ein refraktives Element oder ein diffraktives optisches Element, zum Beispiel eine Linse, umfassen. Gegebenenfalls kann das optische Element auch als photonische Kristallstruktur ausgebildet sein.

Eine Haftschicht 87, eine dielektrische Spiegelschicht 30, eine elektrisch leitfähige Spiegelschicht 90, und/oder ein optisches Element 31 kann auch bei den weiter oben und im Folgenden beschriebenen Bauelementen vorgesehen sein. Weiterhin kann ein jeweiliger Durchbruch bzw. die jeweilige Ausnehmung 11 mit einer dielektrischen Spiegelschicht als Isolationsschicht 10 ausgekleidet sein.

Das Bauelement 1 und insbesondere der erste Kontakt 7 kann eine strahlungsdurchlässige und elektrisch leitfähige Schicht aufweisen. Diese Schicht weist zweckmäßigerweise einen niedrigeren Brechungsindex auf als das den Halbleiterkörper 2 seitens dieser Schicht begrenzende Material. Eine Rückreflexion von Strahlung in den Halbleiterkörper kann so weitergehend verbessert werden. Die strahlungsdurchlässige und elektrisch leitfähige Schicht kann zusätzlich zu der Haftschicht 75 und/oder der Kontaktschicht 71 vorgesehen sein oder die Haftschicht und/oder die Kontaktschicht ersetzen. Die strahlungsdurchlässige und elektrisch leitfähige Schicht kann zum Beispiel durch die mit dem Bezugszeichen 75 gekennzeichnete Schicht gebildet sein, wobei auf die Kontaktschicht 71 gegebenenfalls verzichtet werden kann. Eine zusätzliche strahlungsdurchlässige und elektrisch leitfähige Schicht zu der Haftschicht 75 und der Kontaktschicht 71 ist in Figur 7 nicht explizit dargestellt. Die strahlungsdurchlässige und elektrisch leitfähige Schicht ist zwischen der Reflektorschicht 72 und dem Halbleiterkörper 2 angeordnet. Weiterhin ist die strahlungsdurchlässige und elektrisch leitfähige Schicht bevorzugt zwischen der dielektrischen Spiegelschicht 30 und dem Halbleiterkörper 2 angeordnet. Ein Brechungsindex der strahlungsdurchlässigen und elektrisch leitfähigen Schicht liegt bevorzugt zwischen dem der dielektrischen Spiegelschicht und dem des den Halbleiterkörper seitens der strahlungsdurchlässigen und elektrisch leitfähigen Schicht begrenzenden Halbleitermaterials.

Die strahlungsdurchlässige und elektrisch leitfähige Schicht kann ein Oxid, insbesondere ein Metalloxid, wie zum Beispiel ein Zinnoxid, ein Zinkoxid oder ein Indiumzinnoxid enthalten oder daraus bestehen. Eine TCO-haltige (Transparent Conducting Oxide, strahlungsdurchlässiges und elektrisch leitfähiges Oxid) strahlungsdurchlässige und elektrisch leitfähige Schicht zeichnet sich durch eine hohe Leitfähigkeit in lateraler Richtung bei gleichzeitig hoher Durchlässigkeit für die im aktiven Bereich erzeugte Strahlung aus. Weiterhin können diese Materialien einen niedrigeren Brechungsindex als das den Halbleiterkörper seitens der Schicht begrenzende Material aufweisen, sodass die strahlungsdurchlässige und elektrisch leitfähige Schicht bereits als strahlungsdurchlässige und elektrisch leitfähige Spiegelschicht aufgrund des Brechungsindexsprungs dienen kann. Durch die Schicht hindurch tretende Strahlung kann an der dielektrischen Spiegelschicht und/oder der Reflektorschicht reflektiert werden und von dort aus wieder in den Halbleiterkörper gelangen.

Von besonderem Vorteil ist die strahlungsdurchlässige und elektrisch leitfähige Schicht wenn die dielektrische Spiegelschicht für die Kontaktbildung zum Halbleiterkörper durchbrochen ist und die strahlungsdurchlässige und elektrisch leitfähige Schicht zwischen der dielektrischen Spiegelschicht und dem Halbleiterkörper angeordnet ist. Eine Stromaufweitung kann so zwischen der dielektrischen Spiegelschicht und dem Halbleiterkörper erfolgen. Dies ist besonders zweckmäßig, wenn die elektrische Leitfähigkeit in lateraler Richtung im den Halbleiterkörper seitens der strahlungsdurchlässigen und elektrisch leitfähigen Schicht begrenzenden Material, wie zum Beispiel in p-GaN, vergleichsweise klein ist.

Eine Dicke der strahlungsdurchlässigen und elektrisch leitfähigen Schicht beträgt bevorzugt 200 nm oder weniger, besonders bevorzugt 100 nm oder weniger.

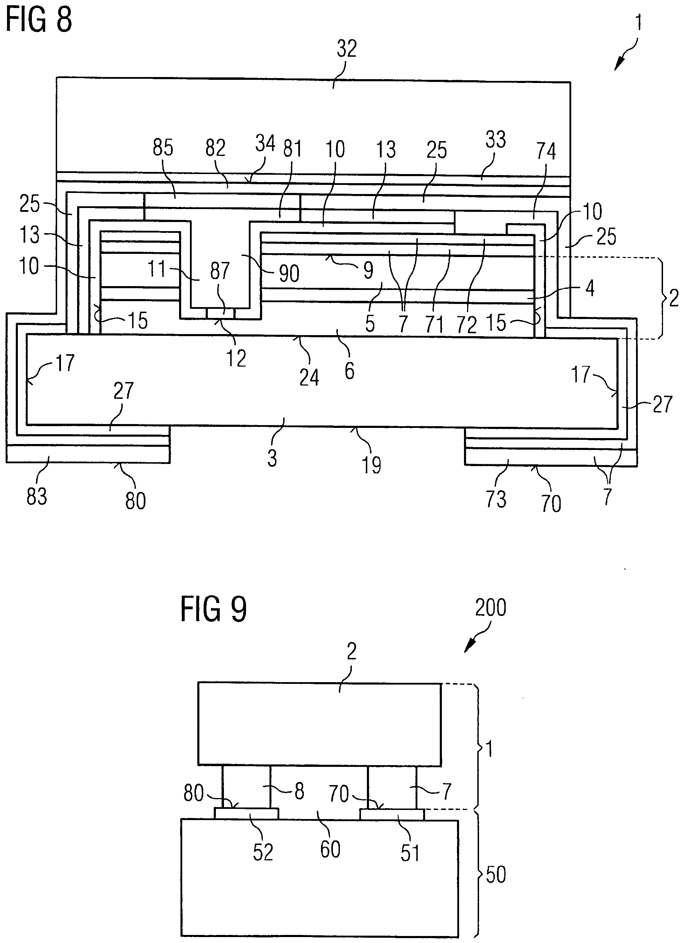

Figur 8 zeigt ein weiteres Ausführungsbeispiel eines optoelektronischen Bauelements anhand einer schematischen Schnittansicht.

Im Wesentlichen entspricht das Bauelement 1 dem im Zusammenhang mit den vorhergehenden Figuren beschriebenen Bauelementen, insbesondere dem Bauelement gemäß Figur 5.

Im Unterschied dazu sind die externen Anschlussflächen 70 und 80 des Bauelements auf der der Reflektorschicht 72 beziehungsweise der Kontaktschicht 71 abgewandten Seite des Halbleiterkörpers angeordnet. Die Anschlussflächen können sich insbesondere über die Auskoppelfläche des Bauelements erstrecken. Die Anschlussflächen 70, 80 können jeweils mittels einer Anschlussschicht 73 beziehungsweise 83, zum Beispiel einer Bondschicht, wie etwa einer Au-Bondschicht, gebildet sein. Die Anschlussschichten 73, 83 sind vorzugsweise jeweils zur Verbindung mit einem Bonddraht vorgesehen. Die Anschlussflächen 70, 80 sind auf der von der Hauptfläche 9 abgewandten Seite des aktiven Bereichs, angeordnet. Die Stromverteilung und die Kontaktbildung zum Halbleiterkörper erfolgen auf der von den Anschlussflächen abgewandten Seite des Halbleiterkörpers. Die Anschlussflächen können so vorteilhaft kleinflächig ausgeführt sein.

Im Wesentlichen entspricht das Bauelement gemäß Figur 8 dem im Zusammenhang mit Figur 5 beschriebenen Bauelement, wobei ergänzend die Anschlussfläche 80 auf die gleiche Seite des Halbleiterkörpers wie die Anschlussfläche 70 geführt ist. Der zweite Kontakt 8 kann über eine Schicht 82 oder eine Mehrzahl von Schichten des zweiten Kontakts, welche sich von der Hauptfläche 9 ausgehend seitlich außen entlang des Halbleiterkörpers neben der Seitenfläche 15 und vorzugsweise auch neben der Seitenfläche 17 des Trägers 3 und über die Oberfläche 24 bzw. die Auskoppelfläche 19 erstrecken kann, auf die gleiche Seite wie die Anschlussfläche 70 geführt sein. Hierzu eignet sich beispielsweise eine geeignete Metall- oder Legierungsschicht.

Weiterhin ist das Bauelement 1 auf einem Wärmeleitkörper 32, zum Beispiel einem Ge-Körper, angeordnet und vorzugsweise befestigt. Die Reflektorschicht 72 bzw. die Kontaktschicht 71 ist dem Wärmeleitkörper 32 zugewandt. Der Halbleiterkörper ist mit dem Wärmeleitkörper 32 über eine thermisch leitende Verbindungsschicht 33, zum Beispiel eine Lotschicht, wie etwa eine Zinn- oder eine Gold-Zinn-Lotschicht, thermisch leitend verbunden. Die Verbindungsschicht 33 kann zwischen der Reflektorschicht 72 und dem Wärmeleitkörper und/oder zwischen der Kontaktschicht 71 und dem Wärmeleitkörper angeordnet sein. Einer der Kontakte 7, 8, zum Beispiel der zweite Kontakt 8, weist bevorzugt einen außenseitig am Bauelement freiliegenden thermischen Anschlussbereich 34 auf. Entlang dieses Anschlussbereichs 34 kann sich die Verbindungsschicht 33 erstrecken. Der thermische Anschlussbereich 34 kann insbesondere zusätzlich zu den elektrischen Anschlussflächen 70, 80 vorgesehen sein. Eine Anschlussfläche, insbesondere beide Anschlussflächen, ist vorzugsweise auf der vom thermischen Anschlussbereich 34 abgewandten Seite des Halbleiterkörpers angeordnet. Im Betrieb des Bauelements entstehende Verlustwärme kann durch die Verbindungsschicht 33 zum Wärmeleitkörper und über den Wärmeleitkörper 32 zuverlässig an die Umgebung abgegeben werden. Die Gefahr eines Ausfalls des Bauelements, insbesondere bei Hochleistungsbauelementen, wird so verringert.

Der thermische Anschlussbereich 32 ist bevorzugt auf der vom Träger 3 abgewandten Seite des Halbleiterkörpers angeordnet. Ein Wärmetransport durch den eventuell schlecht thermisch leitenden Träger wird so vermieden.

Der Wärmeleitkörper 32 kann zusätzlich als Träger dienen, sodass auf den Träger 3 gegebenenfalls verzichtet werden kann. Das Bauelement kann insbesondere als (aufwachs)substratloses Bauelement ausgeführt sein.

Figur 9 zeigt ein Ausführungsbeispiel einer optoelektronischen Vorrichtung anhand einer schematischen Schnittansicht.

Die optoelektronische Vorrichtung 200 weist ein optoelektronisches Bauelement 1 auf. Das Bauelement 1 kann gemäß einem der weiter oben beschriebenen Bauelemente ausgebildet sein, insbesondere als Bauelement, dessen Anschlussflächen für eine elektrisch leitende Schichtverbindung und/oder zur Oberflächenmontage vorgesehen sind. Aus Übersichtlichkeitsgründen ist das Bauelement 1 nur schematisch dargestellt.

Die optoelektronische Vorrichtung 200 weist weiterhin einen Anschlussträger 50 auf. Der Anschlussträger weist zwei elektrisch voneinander isolierte Anschlussleiter 51, 52 auf. Der Anschlussträger 50 kann durch eine Leiterplatte, zum Beispiel eine gedruckte Leiterplatte, oder eine Metallkernplatine, oder durch einen Anschlussträger auf Keramikbasis, der mit leitendem Material für die Anschlussleiter versehen ist, gebildet sein. Die Anschlussleiter 52 und 51 können beispielsweise ein Metall oder eine Legierung enthalten.

Das Bauelement 1 ist mit den Anschlussflächen 70, 80 der

Kontakte 7 beziehungsweise 8 dem Anschlussträger 50 zugewandt. Jeder der Anschlussflächen 70, 80 ist ein gesonderter Anschlussleiter 51 beziehungsweise 52 zugeordnet. Die Anschlussflächen 70, 80 können mit dem jeweiligen Anschlussleiter 51 bzw. 52 elektrisch leitend verbunden, zum Beispiel verlötet, sein.

Die optoelektronische Vorrichtung 200 weist weiterhin ein Füllmaterial 60 auf. Das Füllmaterial 60 ist zweckmäßigerweise zwischen dem Anschlussträger 50 und dem optoelektronischen Bauelement 1 ausgebildet und insbesondere angeordnet. Ein Zwischenraum zwischen dem Bauelement und dem Anschlussträger kann mittels des Füllmaterials 60 be- oder gefüllt sein. Das Füllmaterial 60 kann das optoelektronische Bauelement mechanisch unterstützen. Das Füllmaterial kann mittels einer Formmasse gebildet sein, die vorzugsweise gehärtet ist. Das Füllmaterial kann einen Kunststoff, zum Beispiel ein Harz, wie etwa ein Epoxidharz, enthalten oder daraus bestehen. Das Füllmaterial kann an eine von den Anschlussflächen 70, 80 freie Fläche - also eine nicht von den Anschlussflächen überdeckte Fläche - des Bauelements angrenzen, wobei diese Fläche dem Bauelement vorzugsweise zugewandt ist. Das Füllmaterial wird vorzugsweise vor der Montage des Bauelements auf dem Anschlussträger auf das Bauelement 1 oder den Anschlussträger 50 aufgebracht. Nach dem Befestigen des Bauelements am Anschlussträger kann das Füllmaterial an- oder ausgehärtet werden. Der Halbleiterkörper ist vorzugsweise nicht in das Füllmaterial eingebettet.

Das Füllmaterial kann an den Anschlussträger 50, das Bauelement 1 und/oder an die Kontakte 7 und 8 angrenzen. Das Füllmaterial 60 ist vorzugsweise im Bereich zwischen den Anschlussflächen und/oder zwischen den Kontakten 7 und 8 angeordnet. Besonders zweckmäßig ist das Füllmaterial dann, wenn das Bauelement (aufwachs)substratlos und insbesondere trägerlos, also ohne zusätzliche mechanisch stabilisierende Elemente, ausgeführt ist.

Die Gefahr einer im Betrieb durch thermisch bedingte Verspannungen hervorgerufene Schädigung wird durch das mechanische Unterstützen des Halbleiterkörpers 2 mittels des Füllmaterials 60 verringert.

Das optoelektronische Bauelement 1 kann ohne zusätzlichen Zwischenträger (submount) und insbesondere in Oberflächenmontagetechnik unmittelbar auf den Anschlussträger montiert sein.

Eine Verkapselung 40 oder eine Oberflächenstruktur 21 kann bei allen der weiter oben beschriebenen Bauelemente und nicht nur bei einem im Zusammenhang mit Figur 1 oder 7 beschriebenen Bauelement vorgesehen sein.

Diese Patentanmeldung beansprucht die Priorität der deutschen Patentanmeldung 10 2007 019 775.8 vom 26. April 2007.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

## Patentansprüche

1. Optoelektronisches Bauelement (1) umfassend:
- einen Halbleiterkörper (2), der eine Halbleiterschichtenfolge mit einem zur Strahlungserzeugung geeigneten aktiven Bereich (4) aufweist,
- eine auf dem Halbleiterkörper angeordnete Reflektorschicht (72) und
- zwei elektrische Kontakte (7,8), wobei
ein erster Kontakt (7) der beiden Kontakte auf der der Reflektorschicht zugewandten Seite des aktiven Bereichs elektrisch leitend mit dem Halbleiterkörper verbunden ist, der zweite Kontakt (8) der beiden Kontakte auf der von der Reflektorschicht abgewandten Seite des aktiven Bereichs elektrisch leitend mit dem Halbleiterkörper verbunden ist und die Reflektorschicht zwischen einem Teilbereich des zweiten Kontakts und dem Halbleiterkörper angeordnet ist, und wobei ein Teilbereich des zweiten Kontakts zwischen dem ersten Kontakt und dem Halbleiterkörper angeordnet ist.

2. Optoelektronisches Bauelement nach Anspruch 1,
bei dem die Reflektorschicht (72) für die Kontaktbildung des ersten Kontakts (7) zum Halbleiterkörper (2) ausgespart ist und bei dem die Reflektorschicht für die Kontaktbildung des zweiten Kontakts (8) zum Halbleiterkörper ausgespart ist.

3. Optoelektronisches Bauelement nach einem der vorhergehenden Ansprüche,
bei dem die Reflektorschicht (72) elektrisch isolierend ausgebildet ist.

4. Optoelektronisches Bauelement nach Anspruch 1 oder 2,
bei dem einer der Kontakte (7,8) die Reflektorschicht (72) aufweist.

5. Optoelektronisches Bauelement nach einem der vorhergehenden Ansprüche,
bei dem sich der zweite Kontakt (8) neben einer den Halbleiterkörper (2) lateral begrenzenden Seitenfläche (15) von der einen Seite des aktiven Bereichs (4) bis zur anderen Seite des aktiven Bereichs erstreckt und auf dieser anderen Seite elektrisch leitend mit dem Halbleiterkörper verbunden ist.

6. Optoelektronisches Bauelement nach einem der vorhergehenden Ansprüche,
bei dem der aktive Bereich (4) eine Mehrzahl von Durchbrüchen (11,26) aufweist und sich der zweite Kontakt (8) durch den Durchbruch bzw. die Durchbrüche erstreckt, wobei der zweite Kontakt im Bereich des Durchbruchs bzw. der Durchbrüche elektrisch von dem aktiven Bereich isoliert ist.

7. Optoelektronisches Bauelement nach Anspruch 6,
bei dem eine Wand (110) des jeweiligen Durchbruchs (11,26) schräg zum aktiven Bereich (4) verläuft.

8. Optoelektronisches Bauelement nach Anspruch 6 oder 7,
bei dem der zweite Kontakt (8) im Bereich des Durchbruchs eine elektrisch leitfähige Spiegelschicht (90) aufweist.

9. Optoelektronisches Bauelement nach Anspruch 8,
bei dem der zweite Kontakt (8) eine Kontaktschicht (87) aufweist und diese Kontaktschicht zwischen der elektrisch leitfähigen Spiegelschicht (90) und dem Halbleiterkörper (2) angeordnet ist.

10. Optoelektronisches Bauelement nach einem der Ansprüche 4 bis 9,
bei dem zwischen der elektrisch leitfähigen Reflektorschicht (72) und dem Halbleiterkörper eine dielektrische Spiegelschicht (30) angeordnet ist.

11. Optoelektronisches Bauelement nach einem der vorhergehenden Ansprüche,
bei dem zwischen der Reflektorschicht (72) und dem Halbleiterkörper (2) eine Haftschicht (75) für den ersten Kontakt (7) angeordnet ist.

12. Optoelektronisches Bauelement nach einem der vorhergehenden Ansprüche,
bei dem eine vom aktiven Bereich (4) abgewandte Anschlussfläche (70,80) eines der Kontakte (7,8) auf der von der Reflektorschicht (72) abgewandten Seite des aktiven Bereichs (4) angeordnet ist.

13. Optoelektronisches Bauelement nach Anspruch 12,
bei dem beide Kontakte (7,8) eine vom aktiven Bereich (4) abgewandte Anschlussfläche (70,80) aufweisen und beide Anschlussflächen auf der gleichen Seite des aktiven Bereichs angeordnet sind.

14. Optoelektronisches Bauelement nach einem der Ansprüche 1 bis 12,
bei dem die Kontakte (7,8) jeweils eine vom aktiven Bereich (4) abgewandte Anschlussfläche (70,80) aufweisen und beide Anschlussflächen (70,80) auf verschiedenen Seiten des aktiven Bereichs angeordnet sind.

15. Optoelektronisches Bauelement nach einem der vorhergehenden Ansprüche,
bei dem der Halbleiterkörper (2) epitaktisch gewachsen ist und das Bauelement (1) frei von einem Aufwachssubstrat für Halbleiterschichten des Halbleiterkörpers ist.

## Claims

1. Optoelectronic component (1) comprising:
- a semiconductor body (2), which has a semiconductor layer sequence having an active region (4) suitable for generating radiation,
- a reflector layer (72) arranged on the semiconductor body, and
- two electrical contacts (7, 8), wherein
a first contact (7) of the two contacts on the side of the active region facing the reflector layer is electrically conductively connected to the semiconductor body, the second contact (8) of the two contacts on the side of the active region facing away from the reflector layer is electrically conductively connected to the semiconductor body, and the reflector layer is arranged between a partial region of the second contact and the semiconductor body, and wherein a partial region of the second contact is arranged between the first contact and the semiconductor body.

2. Optoelectronic component according to Claim 1,
wherein the reflector layer (72) is cut out for the contact formation of the first contact (7) to the semiconductor body (2), and wherein the reflector layer is cut out for the contact formation of the second contact (8) to the semiconductor body.

3. Optoelectronic component according to either of the preceding claims,
wherein the reflector layer (72) is embodied in an electrically insulating fashion.

4. Optoelectronic component according to Claim 1 or 2,
wherein one of the contacts (7, 8) has the reflector layer (72).

5. Optoelectronic component according to any of the preceding claims,
wherein the second contact (8) extends alongside a side surface (15), laterally delimiting the semiconductor body (2), from one side of the active region (4) as far as the other side of the active region and, on this other side, is electrically conductively connected to the semiconductor body.

6. Optoelectronic component according to any of the preceding claims,
wherein the active region (4) has a plurality of perforations (11, 26), and the second contact (8) extends through the perforation or the perforations, wherein the second contact is electrically insulated from the active region in the region of the perforation or perforations.

7. Optoelectronic component according to Claim 6,
wherein a wall (110) of the respective perforation (11, 26) runs obliquely with respect to the active region (4).

8. Optoelectronic component according to Claim 6 or 7,
wherein the second contact (8) has an electrically conductive mirror layer (90) in the region of the perforation.

9. Optoelectronic component according to Claim 8,
wherein the second contact (8) has a contact layer (87), and said contact layer is arranged between the electrically conductive mirror layer (90) and the semiconductor body (2).

10. Optoelectronic component according to any of Claims 4 to 9,
wherein a dielectric mirror layer (30) is arranged between the electrically conductive reflector layer (72) and the semiconductor body.

11. Optoelectronic component according to any of the preceding claims,
wherein an adhesion layer (75) for the first contact (7) is arranged between the reflector layer (72) and the semiconductor body (2).

12. Optoelectronic component according to any of the preceding claims,
wherein a connection area (70, 80) - facing away from the active region (4) - of one of the contacts (7, 8) is arranged on the side of the active region (4) facing away from the reflector layer (72).

13. Optoelectronic component according to Claim 12,
wherein both contacts (7, 8) have a connection area (70, 80) facing away from the active region (4), and both connection areas are arranged on the same side of the active region.

14. Optoelectronic component according to any of Claims 1 to 12,
wherein the contacts (7, 8) in each case have a connection area (70, 80) facing away from the active region (4), and both connection areas (70, 80) are arranged on different sides of the active region.

15. Optoelectronic component according to any of the preceding claims,
wherein the semiconductor body (2) is grown epitaxially, and the component (1) is free of a growth substrate for semiconductor layers of the semiconductor body.

## Revendications

1. Composant optoélectronique (1) comprenant :
- un corps semi-conducteur (2) comportant une succession de couches semi-conductrices avec une zone active (4) adaptée à la production d'un rayonnement ;
- une couche réfléchissante (72) disposée sur le corps semi-conducteur ; et
- deux contacts électriques (7, 8) ;
un premier contact (7) parmi les deux contacts étant relié, sur le côté de la zone active orienté vers la couche réfléchissante, de façon électriquement conductrice au corps semi-conducteur, le deuxième contact (8) parmi les deux contacts étant relié, sur le côté de la zone active opposé à la couche réfléchissante, de façon électriquement conductrice au corps semi-conducteur et la couche réfléchissante étant disposée entre une région partielle du deuxième contact et le corps semi-conducteur et une région partielle du deuxième contact étant disposée entre le premier contact et le corps semi-conducteur.

2. Composant optoélectronique selon la revendication 1, dans lequel la couche réfléchissante (72) est évidé pour former un contact entre le premier contact (7) et le corps semi-conducteur (2) et dans lequel la couche réfléchissante est évidée pour former un contact entre le deuxième contact (8) et le corps semi-conducteur.

3. Composant optoélectronique selon l'une quelconque des revendications précédentes, dans lequel la couche réfléchissante (72) est réalisée de façon électriquement isolante.

4. Composant optoélectronique selon la revendication 1 ou 2, dans lequel un des contacts (7, 8) comporte la couche réfléchissante (72).

5. Composant optoélectronique selon l'une quelconque des revendications précédentes, dans lequel le deuxième contact (8) s'étend à côté d'une surface latérale (15) délimitant en côté le corps semi-conducteur (2), en partant du premier côté de la zone active (4) jusqu'à l'autre côté de la zone active et est relié sur cet autre côté de façon électriquement conductrice au corps semi-conducteur.

6. Composant optoélectronique selon l'une quelconque des revendications précédentes, dans lequel la zone active (4) comporte une pluralité de passages traversants (11, 26) et dans lequel le deuxième contact (8) s'étend à travers le passage traversant et/ou les passages traversants, le deuxième contact étant isolé sur le plan électrique par rapport à la zone active dans la région du passage traversant et/ou des passages traversants.

7. Composant optoélectronique selon la revendication 6, dans lequel une paroi (110) du passage traversant (11, 26) respectif s'étend de façon oblique par rapport à la zone active (4).

8. Composant optoélectronique selon la revendication 6 ou 7, dans lequel le deuxième contact (8) comporte une couche réfléchissante (90) électriquement conductrice dans la région du passage traversant.

9. Composant optoélectronique selon la revendication 8, dans lequel le deuxième contact (8) comporte une couche de contact (87) et dans lequel cette couche de contact est disposée entre la couche réfléchissante (90) électriquement conductrice et le corps semi-conducteur (2).

10. Composant optoélectronique selon l'une quelconque des revendications 4 à 9, dans lequel une couche réfléchissante (30) diélectrique est disposée entre la couche réfléchissante (72) électriquement conductrice et le corps semi-conducteur.

11. Composant optoélectronique selon l'une quelconque des revendications précédentes, dans lequel une couche adhésive (75) prévue pour le premier contact (7) est disposée entre la couche réfléchissante (72) et le corps semi-conducteur (2).

12. Composant optoélectronique selon l'une quelconque des revendications précédentes, dans lequel une surface de raccordement (70, 80), opposée à la zone active (4), d'un des contacts (7, 8) est disposée sur le côté de la zone active (4) opposé à la couche réfléchissante (72).

13. Composant optoélectronique selon la revendication 12, dans lequel les deux contacts (7, 8) comportent une surface de raccordement (70, 80) opposée à la zone active (4) et dans lequel les deux surfaces de raccordement sont disposées sur le même côté de la zone active.

14. Composant optoélectronique selon l'une quelconque des revendications 1 à 12, dans lequel les contacts (7, 8) comportent respectivement une surface de raccordement (70, 80) opposée à la zone active (4) et dans lequel les deux surfaces de raccordement (70, 80) sont disposées sur des côtés différents de la zone active.

15. Composant optoélectronique selon l'une quelconque des revendications précédentes, dans lequel le corps semi-conducteur (2) a une croissance épitactique et dans lequel le composant (1) est exempt de substrat de croissance pour les couches semi-conductrices du corps semi-conducteur.
